# EUROPEAN PATENT APPLICATION

(11) **EP 3 163 436 A1**
(43) Date of publication of application: **03.05.2017**
(21) Application number: 15812410.7
(22) Date of filing: 25.06.2015
(51) Int. Cl.: G06F 9/44

(54) **VISUAL SOFTWARE MODELING METHOD BASED ON SOFTWARE META-VIEW FOR CONSTRUCTING SOFTWARE VIEW**

(30) Priority: 25.06.2014 CN 201410291086
(71) Applicant: Chengdu Puzhong Software Limited Company, Chengdu, Sichuan 610041 (CN)
(72) Inventor: FU, Changming, Sichuan 610057 (CN); LONG, Chunsheng, Chengdu Sichuan 610041 (CN); TANG, Hong, Chengdu Sichuan 610045 (CN)
(74) Representative: Gallego Jiménez, José Fernando
(86) International application number: PCT/CN2015/000455
(87) International publication number: WO 2015/196784

(57) **Abstract**

Visual software modeling method based on software meta-view for constructing software view. After determining basic constituents of the software meta-view, the present invention constructs software views through the software hierarchy view, the software interface views, the software interaction views, the software algorithm view, the software process view, and the software transfer view as step features and thereby provides a specification for visual software modeling activities in various fields; such specification has advantages including generality and convenience; the software views constructed through the present invention is executable, has a clear structure, adjustable hierarchies, and controllable granularities for modeling; this method supports both top-down analysis and bottom-up integration for modeling in various software modeling; the modeling method is simple and full visual, thereby even those not skilled in any modeling language nor computer programming language can easily and independently construct the software view, eliminating the tedious and unnecessary communication with and dependence on professional modelers and application developers, greatly reducing modeling time.

## Description

### TECHNICAL FIELD

The present invention relates to the technical field of software engineering, and more specifically, a visual software modeling method based on software meta-view for constructing software view and computer program product thereof.

### TECHNICAL BACKGROUND

Nowadays, with rapidly developing information technology, a software is playing an increasingly important role in our living and development. The object-oriented software method has become quite mature and mainstream after the function-oriented method, process-oriented method etc. However, many inadequacies for the object-oriented method have exposed as software systems become more complex and thus a model-driven method has become a pursued ideal software designing method. A core idea of the model-driven software method is in that software developers focus on constructing software models and representing knowledges as the software models and computers automatically convert the software models into executable program codes. Although the idea of the model-driven method has been proposed long before, in the industry, it is substantially present in a level of concept, slogan, and exploring even after last two decades of efforts, so that the object-oriented method still is a mainstream in actual applications. The most basic reasons for slow developing of the model-driven method is considered being lack of a method capable of supporting to simply and effectively construct software models. In fact, the software modeling is the core activity for software developing despite software methods.

In practical activities for the software modeling, graphically describing software views of the software models has become the first choice due to its intuitiveness. These views for describing the software models are referred to as software views. A base view following these software views, referred to as a software meta-view, can be obtained by abstracting these software view. The software meta-view is a view describing software models, is an abstraction of the software views, and provides a precise definition of a perfect set of components and rules required for creating rigorous system views. The system meta-view is used as a specification for visually performing the software modeling and plays a decisive role in the quality of the software view and the efficiency of software modeling. Thus, study of the software meta-view has been a major focus. The MOF, which is proposed by OMG and is widely recognized in the industry, is systemic study on the software modeling. The MOF includes a set of four layers of view descripting mechanisms whose layer M1 is the software meta-view. The UML (Unified Modeling Language), which belongs to the M1 layer, is the current mainstream industry standard for object oriented visual modeling language. In fact, even though the UML clearly states that it neither is a methodology nor provide any software modeling method and is only a graphical descriptive language for descripting modeling methods, it is used as a software meta-view to a large extent. Unfortunately, the UML has the following drawbacks: Firstly, it lacks of the executability: since the UML is substantially lacks a rigorous theoretical support for modeling, the software view constructed by using UML is lack of executability, i.e., the software view constructed by using UML is lack of sufficiency and consistency information by which the software view constructed by using UML is automatically converted into an executable software, and thus the yielded software must be manually edited through codes in order to be executable by computers. This drawback further makes the UML only be a supplementary expression tool for analyzing softwares rather than a true software meta model for constructing executable software views. Secondly, it is code- oriented: although the UML states it is a view descripting language independent of specific languages and platforms, it is substantially oriented towards to expression tools by which the programmers employ object-oriented programming languages in analyzing and designing programs. Such a programmer-oriented code directing makes "paying great attention to the realization, and paying little attention to the service" have become an industry ill in the software developing. Thirdly, it is difficult to use: the UML creates a lot of concepts, relations and diagrams. Relationships among these concepts, relations, and diagrams are loose and numerous. The UML is originally designed for programmers. However, the UML's complication and disorder are not only hard for programmers to grasp, and thereby cannot be understood by those skilled in this art.

A visual software modeling method for graphically assembling based on prefabricated components has been widely used for the software modeling in various fields. As a visual software modeling tool widely used in science and engineering, Simlink is a typical representative of this method. There are basic drawbacks in this visual software modeling method for graphically assembling based on prefabricated components as follows: Firstly, the software view must be assembled based on the prefabricated components so that the construction of the software view is seriously subject to the prefabricated components. However, the interfaces of the prefabricated components are fixed, such a visual software modeling method is usually applied to the field-specific modeling based on component libraries in specific fields since it does not support to integrate the components with arbitrary interfaces, so that it is not suitable for a universal software modeling. Secondly, because the assembly and the operation rules of the components are also too simple, where the working synergy among the components is basically decided by data transfer relationships, and the complexity for the data transfers makes the readability of the view dramatically deteriorated as the number of the components increases, this method is substantially applied only to describe relatively simple algorithms but cannot describe largely complex software though it states to support the software modeling.

In recent years, rapid developing platforms for specific fields are popular, some of these platforms have achieved to graphically construct a software without any code. The principle for constructing the software by such a rapid platform is an engine mode in which a report template is designed by a report designer and issued to a report engine, and at run time, only related parameters, such as report conditions, are needed to transfer to the report engine which is responsible for querying databases, processing data, and representing the data in various ways. The developers do not need to encode but only need to customize the parameters by a WEB page and store these parameters in a system database or XML file. In run time of the system, the engine will call these parameters to represent them by pages and preform a respective business process. Such a developing platform usually only has a visual assembly method suitable for architectures which collaboratively manages such relatively fixed business contents and regards data as a core, without any explicit software meta-view.

In all, though the model-driven method has been generally recognized as an ideal software developing method, a software meta-view that is easy for ordinary industry personnel to grasp, provides a universal visual software modeling norm, supports software modeling in all fields, particularly visual modeling of a complex software system, and constructs executable views so that the software views are automatically converted into the executable software of the computer by an automatic code generating technology to implement the model-driven software method, currently is still lacking and in demand.

### SUMMARY OF THE INVENTION

In view of the above drawbacks of the prior art, the objective of the present invention is to provide a visual software modeling method based on software meta-view for constructing software view, by which the software view is accomplished using a software hierarchy view, software interface views, software interaction views, software algorithm views, software process views, and software transfer views as step elements, after determining basic constituents of the software meta model; the software views in various specific fields are constructed by using basic graphs in interdisciplinary fields; and a universal software modeling specification easily understood and grasped by those skilled in this art is provided for modeling activities in various fields.

The objective of the present invention is achieved by the following means.
visual software modeling method based on software meta-view for constructing software view, by means of a computer readable storage medium having a computer readable program code stored therein, the computer readable program code containing instructions executable by a processor of a computer software to implement a method of constructing software view by processing data conforming to the software meta-view and describing the software view, the software view being a visual representation of a software model, the software meta-view being a visual representation of a software meta model, the software meta-view comprising:
a software hierarchy graph which represents the software hierarchy view of the software view in a tree structure whose nodes are software component class symbols and which is used as a template to be configured in an actual software modeling environment to form the software hierarchy view of the software view, wherein the software hierarchy view refers to a visual representation of the software hierarchy model, wherein the software component class symbol refers to a visual representation of a software component class, and wherein the tree structure, whose nodes are the software component class symbols, is referred as a software hierarchy tree;
a software interface graph which represents software interface views by an optional structure of an attribute symbol set, a function symbol set, and an event symbol set, the software interface graph is used as a template in the actual software modeling environment to be configured to form the software interface views, wherein the software interface views refers to a visual representation of a software interaction model, wherein the function symbols in the function symbol set include software interaction function symbols, software algorithm function symbols, and software process function symbols, wherein the software interaction function symbol is implemented by a software interaction view, wherein the software algorithm function symbol is implemented by a software algorithm view, and wherein the software process function symbol is implemented by a combination of software process views and software transfer views;
a software interaction graph which represents the software interaction views by a tree structure whose nodes are interaction symbols and which is used as a template in the actual software modeling environment to be configured to form the software interaction views, wherein the software interaction view refers to a visual representation of a software interaction model and the interaction symbol refers to a visual representation of an interaction element having an information interaction function with the actual software modeling environment;
a software algorithm graph which represents software algorithm views by a tree structure whose nodes are operator symbols and which is used as a template in the actual software modeling environment to be configured to form the software algorithm view, wherein the software algorithm view refers to a visual representation of a software algorithm model, and wherein the operator symbol refers to a visual representation of an operator;
a software process graph which represents software process views by combining action symbols as nodes and which is used as a template in the actual software modeling environment to configure the software process views, wherein the software process view refers to a visual representation of a software process model and wherein the action symbol refers to a visual representation of an action;
a software transfer graph which represents software transfer views by an input transfer symbol set and an output transfer symbol set which is used as a template in actual software modeling environment to be configured to form the software transfer views, wherein the software transfer view refers to a visual representation of a software transfer model and the transfer symbol refers to a visual representation of a transfer;
specific steps to construct the software view described by the six graphs being as follows:
1) constructing the software hierarchy view: the software hierarchy graph reading in software hierarchy view commands from the actual software modeling environment, wherein the software hierarchy view command refers to command such as creating a software component class symbol, adding a software component class symbol, selecting a software component class symbol, naming a software component class symbol, or deleting a software component class symbol for the hierarchy tree and wherein the software hierarchy graph performs corresponding operations on the software component class symbol nodes in response to software hierarchy view commands to obtain the software hierarchy view;
2) constructing the software interface views: constructing the software interface view for each software component class symbol of the software hierarchy view obtained in the step 1), the steps for constructing each software interface view including: the software interface graph reading in software interface view commands from the actual software modeling environment, wherein the software interface view command refers to command such as creating, naming, or deleting the attribute symbols, the function symbols, and the event symbols, wherein the software interface graph performs corresponding operations in response to the software interface view commands to obtain the software interface view, and wherein the software interaction views corresponding to the software interaction function symbols are constructed by step 3), wherein the software algorithm views corresponding to the software algorithm function symbols are constructed by step 4), and wherein the software process views corresponding to the software process function symbols are constructed by the step 5);
3) constructing the software interactive views: constructing the software interaction view for each software interaction function symbol obtained in the step 2), steps for constructing each software interaction view including: the software interaction graph reading in software interaction view commands from the actual software modeling environment;
4) constructing the software algorithm views: constructing the software algorithm view for each software algorithm function symbol obtained in the step 2), the steps for constructing each software algorithm view including: the algorithm graph reading in software algorithm view commands from the actual software modeling environment;
5) constructing the software process views: constructing the software process view for each software process function symbol obtained in the step 2), the steps for constructing each software process view including: the software process graph reading in software process view commands from the actual software modeling environment; and
6) constructing the software transfer views: constructing the software transfer view for each action symbol in the software process view obtained in the step 5), the steps for constructing each software transfer view including: the software transfer graph reading in software transfer view commands from the actual software modeling environment, wherein the software transfer view command refers to the command such as adding a transfer symbol set, adding a transfer symbol set, or deleting a transfer symbol set and wherein the software transfer graph performs corresponding operations in response to the software transfer view commands to obtain the software transfer view.

Thereby, the software view constructed by the software hierarchy view, the software interface views, the software interaction views, the software algorithm views, the software process views, and the software transfer views is accomplished.

The software meta-view applies the following modeling rules:
a combination of the software process graph and the software transfer graph provide a universal means to represent and configure functions corresponding to the function symbols; the software interaction graph provides a simplified alternative for replacing the combination of the software process graph and the software transfer graph if only interaction symbols are used to perform the combination to represent and configure function implementations;
a combination of the software process graph and the software transfer graph provide a universal means to represent and configure functions corresponding to the function symbols; the software algorithm graph provides a simplified alternative for replacing the combination of the software process graph and the software transfer graph if only operator symbols are used to perform the combination to represent and configure function implementations;
the software meta-view employs a parent-child structure as a base recursive unit to recursively describe the software view; the parent-child structure refers to a structure of parent-child relationships in a software hierarchy tree, constituted by an involved software component class symbol and all child software component class symbols thereof;
the specific function symbol of the step 2) can only be any one of the software interaction function symbol, the software algorithm function symbol, and software process function symbol;
the software interaction view commands for constructing the software interaction view in the step 3) refer to commands, such as adding an interaction symbol, selecting an interaction symbol, naming an interaction symbol, and deleting an interaction symbol, and the software interaction graph performs corresponding operations in response to the software interaction view commands to obtain the software interaction view; the interaction symbols include operator interaction symbols and component interaction symbols; the operator interaction symbol refers to a visual representation of an operator interaction element and the component interaction symbol refers to a visual representation of a component interaction element, the tree structure whose nodes are the interaction symbols is referred to as an interaction tree, the software interaction graphs include specific forms of, for example, interface graphs, file graphs, database graphs, and communicating graphs; and the software interaction views include specific forms of interface views, file views, database views, and communicating views;
the software algorithm view commands for constructing the software algorithm view in the step 4) refer to commands, such as adding an operator symbol, selecting an operator symbol, naming an operator symbol, and deleting an operator symbol, as well as adding an assignment symbol, selecting an assignment symbol, and deleting an assignment symbol, and the software algorithm graph performs corresponding operations in response to the software algorithm view commands to obtain the software algorithm view; the operator symbols include logic operator symbols and computation operator symbols ; the tree structure whose nodes are the operator symbols is referred to as an algorithm tree; the assignment symbol refers to an assignment relationship representation between two attribute symbols in a set of the algorithm attribute symbols; and the set of the algorithm attribute symbols refers to a collection constituted by a set of attribute symbols of the involved software component class symbols, a set of attribute symbols of all operator symbols, and a set of attribute symbols of all interaction symbols in the software interaction view;
the software process view commands for constructing the software process view in step 5) refer to commands such as adding an action symbol, selecting an action symbol, naming an action symbol, and deleting an action symbol, and the software process graph performs a corresponding operation in response to the software process view commands to obtain the software process view; the action symbols include both component action symbols and operator action symbols; the component action symbol, as a visual representation of a component action, refers to one use of a function symbol in the function symbol set in the parent-child structure, the function symbol set in the parent-child structure refers to a collection constituted by the function symbol set of the involved software component class symbol and function symbol sets of all child software component class symbols in the parent-child structure; the operator action symbol, as a visual representation of an operator action, refers to one use of an operator symbol; the software process views include both the attribute process views and the event process views, the software process graph includes both the attribute process graphs and the event process graphs, and the attribute process graph describes the attribute process view through a process tree as the structure, which is a tree structure constituted by action symbols as nodes; the event process graph describes the event process view by a set of event association symbols as the structure; the event association symbol in the set of event association symbols is an association relationship between an event symbol in a set of event symbols in a parent-child structure and an operator action symbol or a component action symbol; the event symbol set in the parent-child structure is a collection constituted by the event symbol set of the involved software component class symbol and the event symbol sets of all interaction symbols in the interaction view thereof and the event symbol sets of all child software component class symbols and the event symbol sets of all interaction symbols in the interaction views thereof, in the parent-child structure.

Besides the action attribute symbols which refers to the attribute symbols of the component class symbols where the action symbol is, the attribute symbols relevant to the transfer symbols are limited to the parent-child attribute symbol set, which refers to a collection constituted by all attribute symbol sets of the involved software component class symbols and all attribute symbol sets of all child software component class symbols thereof in the parent-child structure.

Alternatively, the attribute symbol sets in the parent-child structure may include the attribute symbol sets of all interaction symbols in the interaction views of the involved software component class symbol and the attribute symbol sets of all interaction symbols in the interaction views of all child software component class symbols in the parent-child structure.

Thus, after determining basic constituents of the software meta-view, the present invention constructs software views through the software hierarchy view, the software interface views, software interaction views, the software algorithm views, the software process views, and the software transfer views as step features and thereby provides a specification for visual software modeling activities in various fields; such specification has advantages including generality and convenience; the software views constructed through the present invention are executable, have clear structures, adjustable hierarchies, and controllable granularities; this modeling method supports both top-down analysis and bottom-up integration for modeling in various software modeling; the modeling method is simple and full visual, thereby even those not skilled in any modeling language nor computer programming language can easily and independently construct the software view, eliminating the tedious and unnecessary communication with and dependence on professional modelers and application developers, greatly reducing modeling time.

In summary, the present invention has obvious advantages over the prior art as follows:
(1) executability: the software view constructed according to the present invention is executable, that is, has an integrity and a full consistency in which the software view can be mapped to a program executable by a computer;
(2) generality: the software view constructed according to the present invention has a clear structure, adjustable hierarchies, controllable granularities, and generality suitable for all types of systems. That is, not only suitable for software algorithm modeling but also rapid prototyping of the system and even more suitable for large, complex software modeling; not only convenient for top-down analysis but also bottom up integration; not only suitable for software integration based on prefabricated units and software expansion based on customized units, but also suitable for distributed software interconnection and communication; not only suitable for practical engineering software modeling, but also suitable for various information software modeling; not only suitable for equipment information software simulation modeling, but also suitable for MIS (management information software) modeling; not only suitable for desktop software modeling, embedded device software modeling, mobile terminal software modeling, but also suitable for LAN software modeling, WAN software modeling, and cloud computation environmental software modeling; not only suitable for applied software modeling, but also suitable for software development platform modeling; and
(3) ease of use: the elements of the present invention are concise, rules thereof are simple, and methods thereof are universal. Even those not skilled in any complex modeling language nor any computer programming language can easily take advantage of the present invention to construct the software view with executability in a relatively short period of time, eliminating the tedious and unnecessary communication with and dependence on professional modelers and application developers, enabling the resultant software view to be more fitted to the expectations of those skilled in this art, and eliminating possible understanding errors of the professional modelers or the application developers; at the same time, because communication time is saved, modeling time is greatly reduced.

### BRIEF DESCRIPTION OF THE DRAWINGS

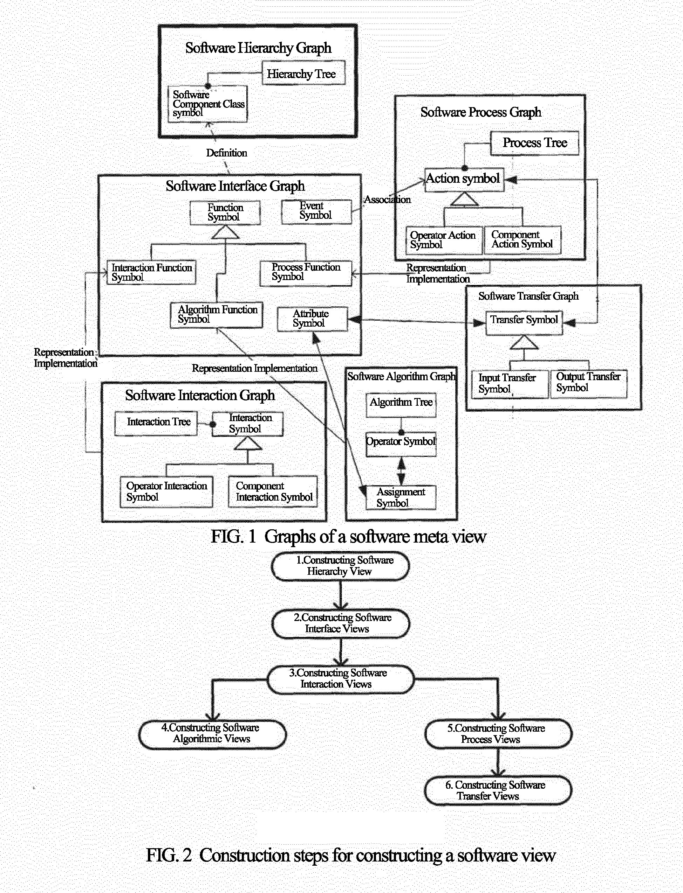

Fig. 1 is graphs of the software meta-view.
Fig. 2 is construction steps for constructing a software view.

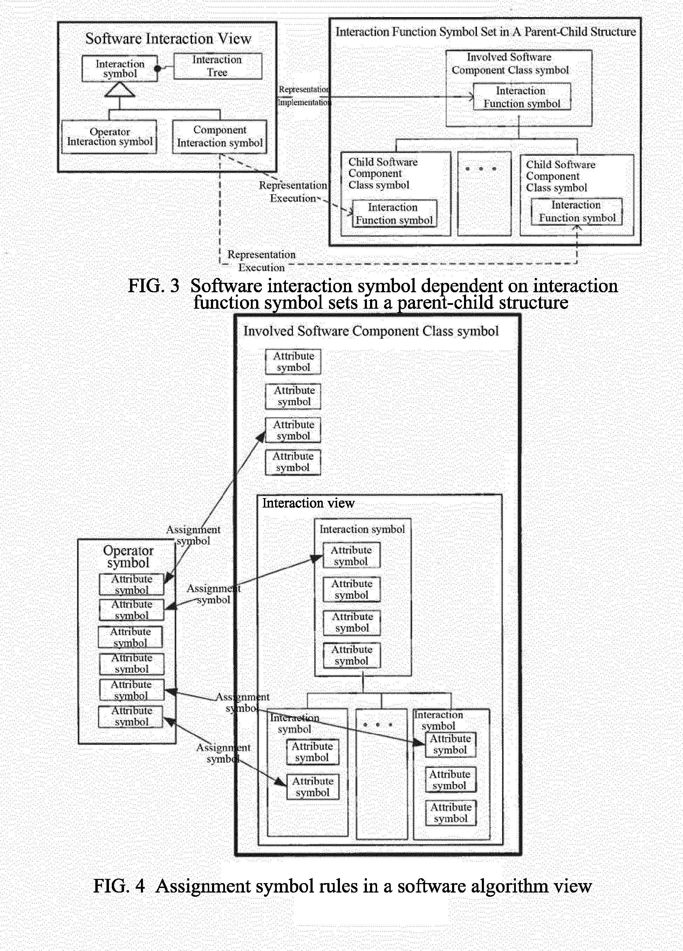

Fig. 3 is a software interaction view.
Fig. 4 is assignment symbol rules in a software algorithm view.

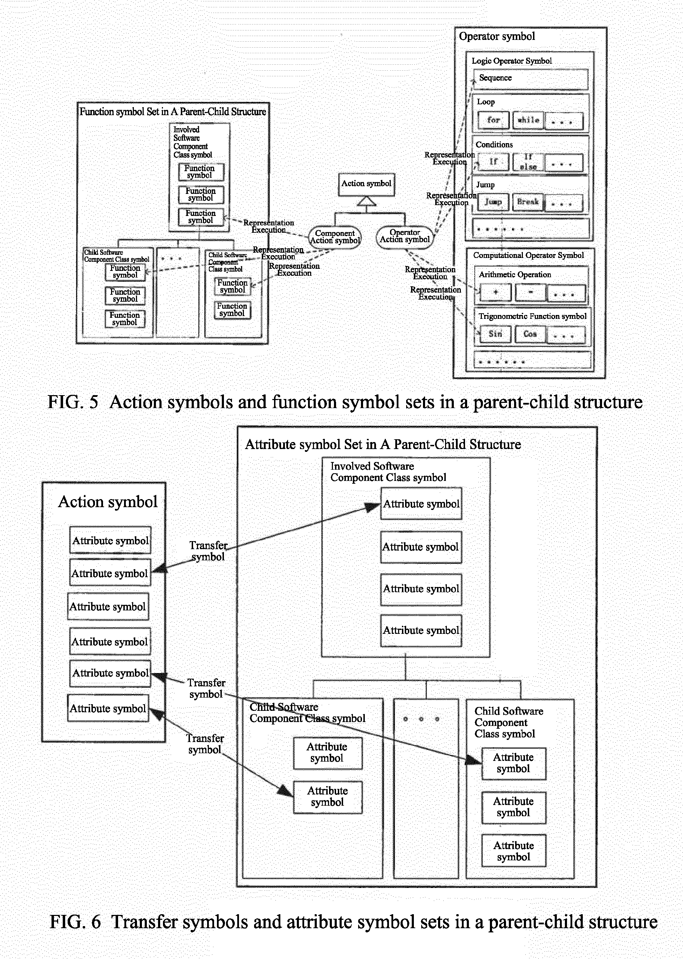

Fig. 5 is action symbols and function symbol sets in a parent-child structure.
Fig. 6 is transfer symbols and attribute symbol sets in a parent-child structure.
Fig. 7 is schematically block diagram of a computer for implementing visual software modeling method based on software meta-view for constructing software view.
Fig. 8 is the business management YWGL hierarchy view.
Fig. 9 is the business management YWGL interface view.
Fig. 10 is the sales management XSGL interface view.
Fig. 11 is the production management SCGL interface view.
Fig. 12 is the purchase management CGGL interface view.
Fig. 13 is the business assistant YWZS interface view.
Fig. 14 is the distributed sales product FXP interface view.
Fig. 15 is the direct sales product ZXP interface view.
Fig. 16 is the main parts ZJ interface view.
Fig. 17 is the auxiliary parts LJ interface view.
Fig. 18 is the finished product CP interface view.
Fig. 19 is the business display interaction view.
Fig. 20 is the sales display interaction view.
Fig. 21 is the production display interaction view.
Fig. 22 is the purchase display interaction view.
Fig. 23 is the distributed sales display interaction view.
Fig. 24 is the direct sales display interaction view.
Fig. 25 is the main parts display interaction view.
Fig. 26 is the auxiliary parts display view.
Fig. 27 is the finished product display interaction view.
Fig. 28 is the product type configuration algorithm view.
Fig. 29 is the sales update algorithm view.
Fig. 30 is the production delivery algorithm view.
Fig. 31 is the production update algorithm view.
Fig. 32 is the purchase implementation algorithm view.
Fig. 33 is the purchase update algorithm view.
Fig. 34 is the distributed sales update algorithm view.
Fig. 35 is the direct sales update algorithm view.
Fig. 36 is the main parts Update algorithm view.
Fig. 37 is the auxiliary parts Update algorithm view.
Fig. 38 is the finished product update algorithm view.
Fig. 39 is the main parts processing algorithm view.
Fig. 40 is the main parts delivery algorithm view.
Fig. 41 is the auxiliary parts processing algorithm view.
Fig. 42 is the auxiliary parts delivery algorithm view.
Fig. 43 is the auxiliary parts receipt algorithm view.
Fig. 44 is the finished product assembly algorithm view.
Fig. 45 is the main business procedure process view.
Fig. 46 is the configuration display and control process view.
Fig. 47 is the business configuration process view.
Fig. 48 is the business instance creation process view.
Fig. 49 is the business instance configuration process view.
Fig. 50 is the business operation process view.
Fig. 51 is the operation display and control process view.
Fig. 52 is the sales display and control process view.
Fig. 53 is the sales operation process view.
Fig. 54 is the production display and control process view.
Fig. 55 is the production operation process view.
Fig. 56 is the production planning process view.
Fig. 57 is the production implementation process view.
Fig. 58 is the purchase display and control process view.
Fig. 59 is the purchase operation process view.
Fig. 60 is the distributed sales display and control process view.
Fig. 61 is the direct sales display and control process view.
Fig. 62 is the main procedure frame loop transfer view.
Fig. 63 is the main procedure condition transfer view.
Fig. 64 is the business operation state negation transfer view.
Fig. 65 is the sales instance creation transfer view.
Fig. 66 is the production instance creation transfer view.
Fig. 67 is the purchase instance creation transfer view.
Fig. 68 is the production configuration traversal transfer view.
Fig. 69 is the production serial number increment transfer view.
Fig. 70 is the production serial number assignment transfer view.
Fig. 71 is the purchase configuration traversal transfer view.
Fig. 72 is the purchase serial number assignment transfer view.
Fig. 73 is the sales serial number reset transfer view.
Fig. 74 is the sales configuration traversal transfer view.
Fig. 75 is the sales serial number assignment transfer view.
Fig. 76 is the sales-production configuration comparison transfer view.
Fig. 77 is the sales-production configuration condition transfer view.
Fig. 78 is the sales-production product name assignment transfer view.
Fig. 79 is the sales-purchase configuration comparison transfer view.
Fig. 80 is the sales-purchase configuration condition transfer view.
Fig. 81 is the sales-purchase product name assignment transfer view.
Fig. 82 is the sales-production operation transfer view.
Fig. 83 is the sales-purchase operation transfer view.
Fig. 84 is the sales receipt transfer view.
Fig. 85 is the shipment quantity summary transfer view.
Fig. 86 is the total shipment quantity summary transfer view.
Fig. 87 is the inventory quantity summary transfer view.
Fig. 88 is the contract quantity summary transfer view.
Fig. 89 is the demand quantity summary transfer view.
Fig. 90 is the order quantity summary transfer view.
Fig. 91 is the main-parts pending processing quantity summary transfer view.
Fig. 92 is the auxiliary parts pending processing quantity summary transfer view.
Fig. 93 is the parts receipt transfer view.
Fig. 94 is the finished product assembly transfer view.

### DETAILED DESCRIPTION OF THE INVENTION

Generally, a computer comprises a central processor, a memory, an Input and Output (I/O) interface, and a bus; and furthermore, the computer is connected with an input and output device and a storage medium. The central processor takes charge of functions of computing and controlling the computer. The central processor may only include one central processing unit, or may include a plurality of central processing units distributed at one or more positions.

The memory medium may be formed by any known computer readable storage medium. For example, a buffer memory may temporarily store some program codes so as to reduce time for extracting codes from a large-capacity memory when the program is run. In the meantime, the memory may reside at a certain physical position, and may be stored in one or more types of data, or may be distributed in different physical systems in different forms. Moreover, the memory may also be distributed in a Local Area Network (LAN) or a Wide Area Network (WAN). The memory may contain program codes for implementing a general modeling method to establish a system view based on a system meta-view, or may contain other codes not shown in the diagram, such as an operating system.

The input and output interface allows the computer to exchange information with the storage medium or another computer. The input and output device contains any known external device type, such as a display device, a keyboard, a mouse, a printer, a sound box, a handheld device, and a facial mask, etc. The bus provides communication connection among respective component parts inside the computer, including a variety of transmission connection forms such as electrical, optical, wireless and other forms. The storage medium includes any known computer readable storage medium, such as a magnetic disc, an optical disc, etc. The storage medium may contain one or more examples of a general system view established by the system meta-view.

A person skilled in the art can know that the present invention can be implemented as an all hardware product, an all software product, or a combination of hardware and software, which is commonly referred to as a module. Moreover, the present invention can be implemented by a computer program product stored in the computer readable medium. The computer readable medium may be, for example, but not limited to an electrical, a magnetic, an optical, an electromagnetic, an infrared or a semiconductor system, apparatus, or device or any combination of the above, and more particularly, the computer readable medium includes, but not limited to, the following: a random access memory (RAM), a read-only memory (ROM), an erasable and programmable read-only memory (EPROM or flash memory), a CD-ROM, an optical storage device, a magnetic storage device, and any combination of the above.

The computer program codes for implementing the method of the present invention can be programmed by one or more programming languages, including, for example, Java, Small, C++, C# and so on, and other process-oriented programming languages such as C. The program codes can be run on a personal computer, a handheld device, or an LAN or WAN.

A person skilled in the art surely knows that the method of the present invention may also be expressed by graphical representations, and such graphical representations all can be implemented as computer program codes, which can be processed by a general-purpose computer, a special-purpose computer and other programmable data processing apparatuses, to achieve the functions indicated by these graphical representations.

Below, a further detailed description of the present invention will be given in conjunction with a specific embodiment in which constructing a business management YWGL software view by using the present invention is demonstrated. It should be known by those skilled in this art that the technical scope of the present invention is not limited to the following demonstrated contents of this embodiment.

### Embodiment: constructing the business management YWGL software view

The present embodiment supposes that the firm's business mode is to profit from selling its own products and outsourcing products and models the business management software for achieving the following business management intentions:
(1) clearly distinguishing three modules: production management, purchase management, and sales management;
(2) configuration: configuring production product type quantities and purchase product type quantities by an interface and configuring sales product type quantities from the production product type quantities and the purchase product type quantities; and
(3) execution function: the sales management module real-time interacts with an actual application environment for contract order quantities and shipment quantities of the direct sales and distributed sales of each type of products, receives delivery information from the production management module and the purchase management module, and issues order information to the production management module and the purchase management module based on the sales status; the production management module and the purchase management module receive order information from the sales management module, receive response order information after completed information from the actual application environment, start an internal process, and submit the delivery information to the sales management module. Each module real-time displays information by an interface.

The detailed procedure for constructing this embodiment's software view is given below.

### Constructing the software hierarchy view

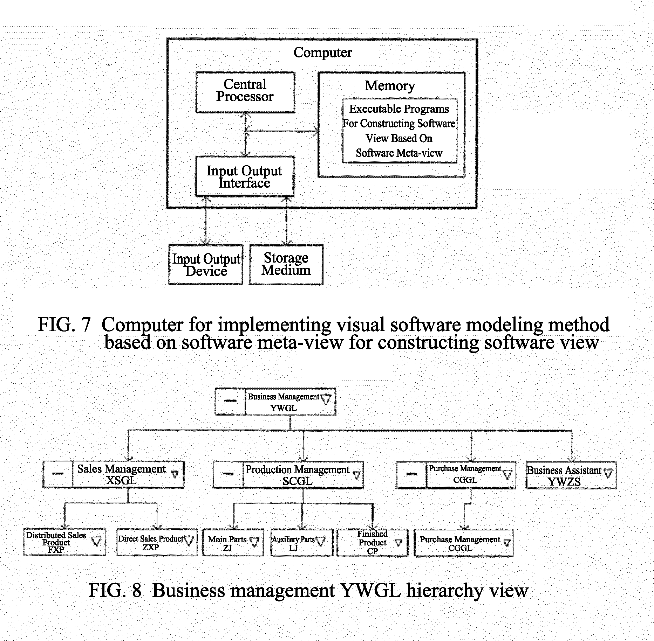

Firstly, for the convenience of understanding, Fig. 8 shows a completed software hierarchy view of the business management YWGL software view.

At the initial state before start of modeling, the software hierarchy graph creates a root node for a software component tree, wherein the software component class symbol of the root node is referred to as a root software component class symbol;
the software hierarchy graph receives the command to select root software component class symbol from the actual software modeling environment and sets the root software component class symbol to the involved software component class symbol in response to the foregoing command; the software hierarchy graph receives the command to modify software component class symbol' name to "business management YWGL" from the actual software modeling environment and modifies the name of the root software component class symbol to "business management YWGL" in response to the foregoing command; the involved software component class symbol is referred to as a business management YWGL software component class symbol in accordance with the name of the root software component class symbol and name for the other software component class symbols may be deduced by analogy, which will not be repeated below; the software hierarchy graph receives the command to set the component instance quantity to 1 from the actual software modeling environment and sets the component instance quantity of the business management YWGL software component class symbol to 1 in response to the foregoing command;
the software hierarchy graph receives the command to add a child software component class symbol from the actual software modeling environment and adds a child software component class symbol for business management YWGL software component class symbol in response to the foregoing command; the software hierarchy graph sets the foregoing child software component class symbol to the involved software component class symbol; the software hierarchy graph receives commands, from the actual software modeling environment, to modify the name of the involved software component class symbol to "sales management XSGL" and modifies the name of the involved software component class symbol to "sales management XSGL" in response to the foregoing commands;
in the foregoing steps, the software hierarchy graph receives the command from the actual software modeling environment to select the business management YWGL software component class symbol and adds, in response to the foregoing command, three child software component class symbols, i.e., a production management SCGL software component class symbol whose instance quantity is 3, a purchase management CGGL software component class symbol whose instance quantity is 2, and a business assistant YWZS software component class symbol whose instance quantity is 1, to the business management YWGL software component class symbol:
in the foregoing steps, the software hierarchy graph receives the command to select the sales management XSGL software component class symbol from the actual software modeling environment and add, in response to the foregoing command, two child software component class symbols, i.e., distributed sales product FXP software component class symbol and direct sales product ZXP software component class symbol, whose instance quantities are 1, to the sales management XSGL software component class symbol; and
in the foregoing steps, the software hierarchy graph receives the command to select the production management SCGL software component class symbol from the actual software modeling environment and adds, in response to the foregoing command, three child software component class symbols, i.e., main parts ZJ software component class symbol whose instance quantity is 1, auxiliary parts LJ software component class symbol whose instance quantity is 1, and finished product CP software component class symbol whose instance quantity is 1, to the production management SCGL software component class symbol.

So far, the software hierarchy view of the business management YWGL software view is accomplished.

### Constructing the software interface models

Next, the procedure for constructing the software interface view for each of the software component class symbols in the software hierarchy view as described above will be given. The software interaction in this embodiment is demonstrated with interface displays as examples and thus it should be appreciated by those skilled in this art that the software interactions in other forms can be similarly handled by taking advantage of the present invention.

### Business management YWGL software interface view

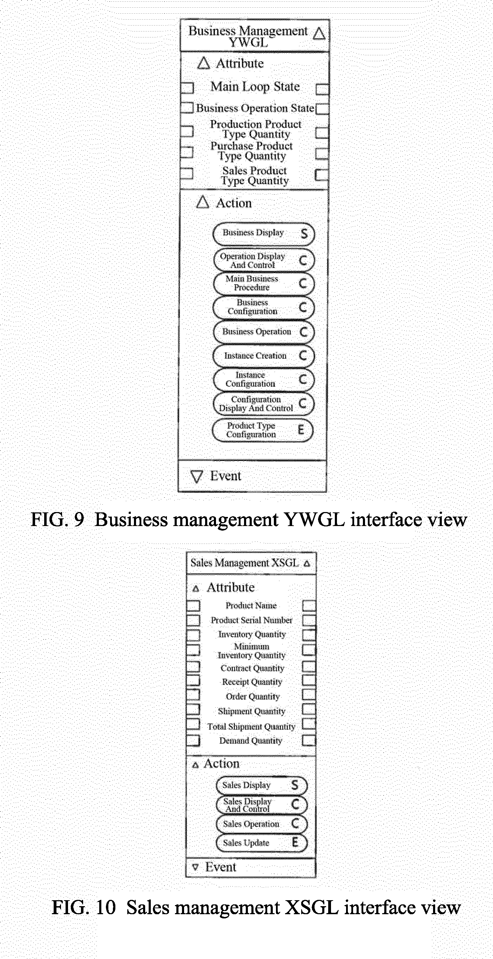

Fig. 9 shows a completed software interface view for business management YWGL software component class symbol, which is shortly referred to as the business management YWGL software interface view, names of other software interface views of the software component class symbols may be deduced by analogy; the procedure for constructing business management YWGL software interface view is as follows:
the software hierarchy graph receives the command to select the business management YWGL software component class symbol from the actual software modeling environment and sets the business management YWGL software component class symbol to the involved software component class symbol in response to the foregoing command;
the software interface graph receives the command to add an attribute symbol from the actual software modeling environment and adds a new attribute symbol to the business management YWGL software component class symbol in response to the foregoing command; the software interface graph sets the foregoing new attribute symbol to the involved attribute symbol; the software interface graph receives the command to modify the data type of the involved attribute symbol as "bool" from the actual software modeling environment and modifies the data type of the involved attribute symbol to "bool"; the software interface graph receives the command to modify the attribute symbol name of the involved attribute symbol to the word "main loop state" from the actual software modeling environment and modifies the attribute symbol name of the involved attribute symbol to the main loop state in response to the foregoing command; the attribute symbol whose attribute symbol name is the main loop state is shortly referred to as the main loop state attribute symbol, and names for the subsequent attribute symbols may be deduced by analogy, which will not be repeated below; and the software interface graph receives the command to set the attribute value of the involved attribute symbol to "true" from the actual software modeling environment and sets the attribute value of the main loop state attribute symbol to "true" in response to the foregoing command;
in the foregoing steps, the software interface graph adds the following attribute symbols to the business management YWGL interface model: a business operation state attribute symbol whose data type is the "bool" type and the attribute value is the "true"; a production product type quantity attribute symbol whose data type is the integer and the attribute value is 3; a purchase product type quantity attribute symbol whose data type is the integer and the attribute value is 2; a sales product type quantity attribute symbol whose data type is the integer and the attribute value is 0;
the software interface graph receives the command to add a function symbol from the actual software modeling environment and adds a software display function symbol to the business management YWGL software component class symbol in response to the foregoing command; the software interface graph sets the newly added software display function symbol to the involved function symbol; the software interface graph receives the command to modify the function symbol name of the involved function symbol to the word "business display" from the actual software modeling environment and modifies the function symbol name of the involved function symbol to the business display in response to the foregoing command, wherein such a function symbol whose function symbol name is referred to as a business display is shortly referred to as the business display function symbol, short names for the subsequent function symbols may be deduced by analogy, which will not be repeated below; and
in the foregoing steps, the software interface graph adds the following software process function symbols to the business management YWGL interface model: an operation display and control function symbol, a main business procedure (which is the entry function symbol of the software view), a business configuration function symbol, a business operation function symbol, an instance creation function symbol, an instance configuration function symbol, configuration display and control function symbol, and a product type configuration function symbol.

So far, the business management YWGL interface view is accomplished.

### Sales management XSGL interface view

Fig. 10 shows a completed sales management XSGL interface view whose construction process is similar to that of the "business management YWGL interface view" and the content thereof is as follows:
the attribute symbol set contains: a product name attribute symbol whose data type is "string" and attribute value is "sales product"; a product serial number attribute symbol whose data type is "int" and attribute value is "1"; an inventory quantity attribute symbol whose data type is "int" and attribute value is "0"; a minimum inventory quantity attribute symbol whose data type is "int" and attribute value is "0"; a contract order quantity attribute symbol whose data type is "int" and attribute value is "0"; a receipt quantity attribute symbol whose data type is "int" and attribute value is "0"; an order quantity attribute symbol whose data type is "int" and attribute value is "0"; a shipment quantity attribute symbol whose data type is "int" and attribute value is "0"; a total shipment quantity attribute symbol whose data type is "int" and attribute value is "0"; and a demand quantity attribute symbol whose data type is "int" and attribute value is "0"; and
the function symbol set contains three process function symbols: internal order function symbol, sales shipment function symbol, and sales order function symbol.

### Production management SCGL interface view

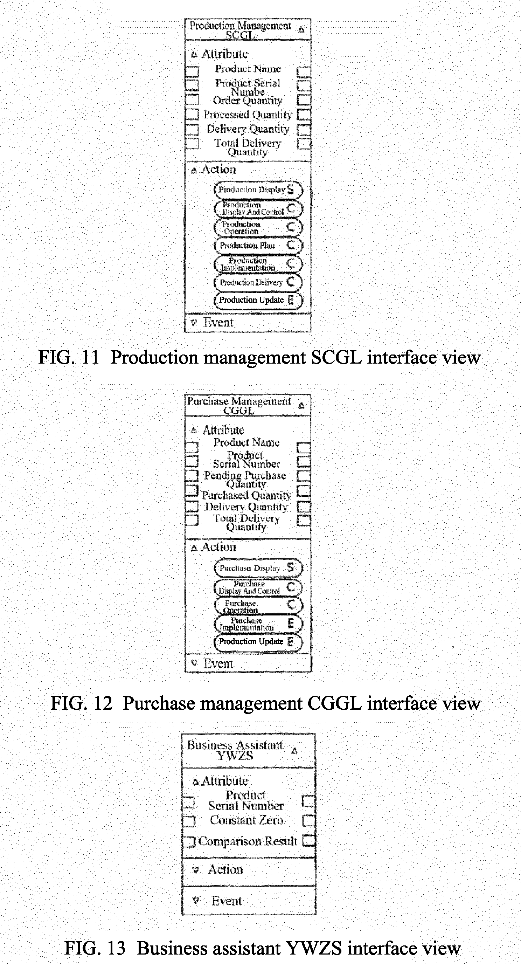

Fig. 11 shows a completed production management SCGL interface view whose construction process is similar to that of "business management YWGL interface view" and the content thereof is as follows:
the attribute symbol set contains: a product name attribute symbol whose data type is "string" and attribute value is "self-developed product"; a product serial number attribute symbol whose data type is "int" and attribute value is "1"; an order quantity attribute symbol whose data type is "int" and attribute value is "0"; a processed quantity attribute symbol whose data type is "int" and attribute value is "0"; a delivery quantity attribute symbol whose data type is "int" and attribute value is "0"; and a total delivery quantity attribute symbol whose data type is "int"and attribute value is "0"; and
the function symbol set contains three process function symbols: production planning function symbol, production implementation function symbol, and production delivery function symbol.

### Purchase management CGGL interface view

Fig. 12 shows a completed purchase management CGGL interface view whose construction process is similar to that of "business management YWGL interface view" and the content thereof is as follows:
the attribute symbol set contains: a product name attribute symbol whose data type is "string" and attribute value is "purchase product"; a product serial number attribute symbol whose data type is "int" and attribute value is "1"; a pending purchase quantity attribute symbol whose data type is "int" and attribute value is "0"; a purchased quantity attribute symbol whose data type is "int" and attribute value is "0"; a delivery quantity attribute symbol whose data type is "int" and attribute value is 0; and a total delivery quantity attribute symbol whose data type is "int" and attribute value is "0" the; and
the function symbol set contains two interaction function symbols, i.e., a purchase display interaction function symbol and a purchase operation interaction function symbol, and two algorithm function symbols, i.e., a purchase implementation algorithm function symbol and a purchase update algorithm function symbol.

### Business assistant YWZS interface view

Fig. 13 is the accomplished business assistant YWZS interface view whose construction procedure is similar to that of the "business management YWGL interface view" and the content thereof is as follows:
the attribute symbol set contains: a product serial number attribute symbol whose data type is the integer and the attribute value is 0; a constant zero attribute symbol whose data type is the integer and the attribute value is 0; and a comparison result attribute symbol whose data type is the "bool" type and the attribute value is "true".

### Distributed sales product FXP interface view

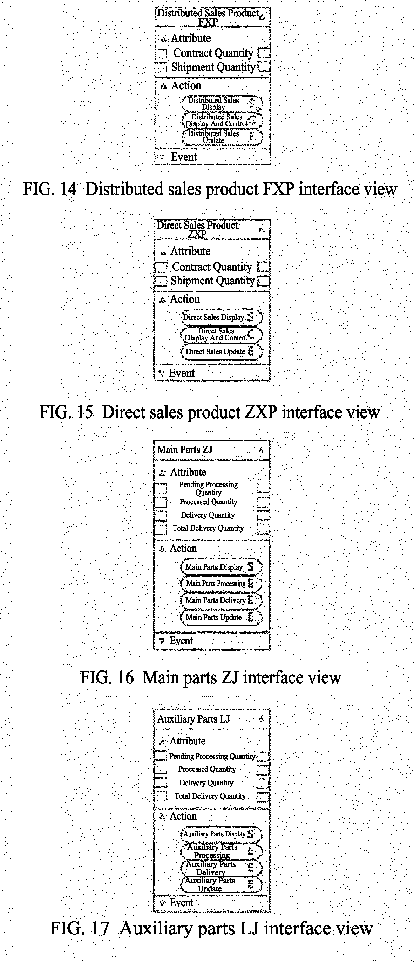

Fig. 14 shows a completed distributed sales product FXP interface view whose construction procedure is similar to that of "business management YWGL interface view" and the content thereof is as follows:
the attribute symbol set contains: a minimum inventory quantity attribute symbol whose data type is "int" and attribute value is "5"; a contract order quantity attribute symbol whose data type is "int" and attribute value is "12"; and a shipment quantity attribute symbol whose data type is "int" and attribute value is "8"; and
the function symbol set contains two software interaction function symbols, i.e., a distributed sales display function symbol and a distributed sales display and control function symbol, and a software algorithm function symbol, i.e., a distributed sales update function symbol.

### Direct sales product ZXP interface view

Fig. 15 shows a completed direct sales product ZXP interface view whose construction procedure is similar to that of "business management YWGL interface view" and the content thereof is as follows:
the attribute symbol set contains: a minimum inventory quantity attribute symbol whose data type is "int" and attribute value is "6"; a contract order quantity attribute symbol whose data type is "int" and attribute value is "3"; and a shipment quantity attribute symbol whose data type is "int" and attribute value is "4"; and
the function symbol set contains three function symbols, i.e., a direct sales display function symbol, a direct sales display and control function symbol, and a direct sales update function symbol.

### Main parts ZJ interface view

Fig. 16 shows a completed main parts ZJ interface view whose construction procedure is similar to that of "business management YWGL interface view" and the content thereof is as follows:
the attribute symbol set contains: a main parts name attribute symbol whose data type is "string" and attribute value is "main parts"; a pending processing quantity attribute symbol whose data type is "int"and attribute value is "0"; a processed quantity attribute symbol whose data type is "int"and attribute value is "0"; a delivery quantity attribute symbol whose data type is "int"and attribute value is "0"; and a total delivery quantity attribute symbol whose data type is "int" and attribute value is "0"; and
the function symbol set contains a software interaction function symbol, i.e., a main parts display function symbol, and three algorithm function symbols: a main parts processing function symbol, a main parts delivery function symbol, and main parts update function symbol.

### Auxiliary parts LJ interface view

Fig. 17 shows a completed auxiliary parts LJ interface view whose construction procedure is similar to that of "business management YWGL interface view" and the content thereof is as follows:
the attribute symbol set contains: an auxiliary parts name attribute symbol whose data type is "string" and attribute value is "auxiliary parts"; a pending processing quantity attribute symbol whose data type is "int"and attribute value is "0"; a processed quantity whose data type is "int" and attribute value is "0"; a delivery quantity attribute symbol whose data type is "int" and attribute value is "0"; and a total delivery quantity attribute symbol whose data type is "int" and attribute value is "0"; and
the function symbol set contains a software interaction function symbol, i.e., an auxiliary parts display function symbol, and three software algorithm function symbols: an auxiliary parts processing function symbol, and an auxiliary parts delivery function symbol, and an auxiliary parts update function symbol.

### Finished product CP interface view

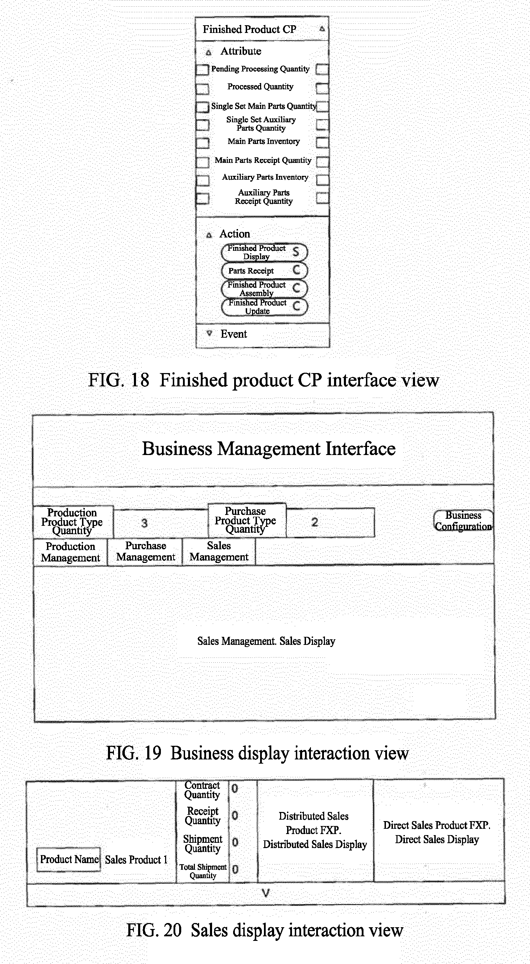

Fig. 18 shows a completed finished product CP interface view whose construction procedure is similar that of "business management YWGL interface view" and the content thereof is as follows:
the attribute symbol set contains: a finished product name attribute symbol whose data type is "string" and attribute value is "finished product"; a pending processing quantity attribute symbol whose data type is "int" and attribute value is "0", a processed quantity attribute symbol whose data type is "int"and attribute value is "0"; a single set main parts quantity attribute symbol whose data type is "int" and attribute value is "2"; a single set auxiliary parts quantity attribute symbol whose data type is "int"and attribute value is "6"; a main parts inventory quantity attribute symbol whose data type is "int" and attribute value is "0"; a main parts receipt quantity attribute symbol whose data type is "int" and attribute value is "0"; a parts inventory quantity attribute symbol whose data type is "int" and attribute value is "0"; and a parts receipt quantity attribute symbol whose data type is "int" and attribute value is "0"; and
the function symbol set contains a software interaction function symbol for the finished product display and three software algorithm function symbols: a parts receipt function symbol, a finished product assembly function symbol, and a finished product update function symbol.

### Constructing the software interaction models

Next, the construction procedure of each of the software interaction views will be described in detail.

### Business display software interaction view

Fig. 19 shows the accomplished software interaction view for implementing the business display function symbols in the business management YWGL interface view, which is shortly referred to as the business display interaction view. Short names of the software interaction views in the other interface views may be deduced by analogy, which will not be repeated below. The construction procedure of the business display interaction view is as follows:
the software interface graph receives and responds to the command from the actual software modeling environment to set the business display function symbol for the business management YWGL software component class symbol to the involved function symbol;
the software interaction graph receives and responds to the command from the actual software modeling environment to successively accomplish the following operations: creating a window symbol shortly referred to as a business management window symbol and a free layout symbol as a root interaction symbol of the business management window symbol, which is referred to as a root layout symbol of the business management;
in the foregoing steps, adding a tag symbol as a child interaction symbol for the root layout symbol of the business management and setting a text content attribute symbol of the involved tag symbol as the word "business management interface", wherein the tag symbol is referred to as a business management interface tag symbol for the convenience of describing and text content attribute symbols for other symbols may be deduced by analogy, which will not be repeated below;
the software interaction graph receives and responds to the command from the actual software modeling environment to add a stack layout symbol, shortly referred to as a business configuration stack layout symbol, for the business management root layout symbol; the software interaction graph receives and responds to the command from the actual software modeling environment to add the following operator interaction symbols as child interaction symbols thereof: adding a tag symbol whose background color is set to gray and the text is "production product type quantity"; adding a textbox symbol whose initial value is set to 3, shortly referred to as a production product type quantity textbox symbol; adding a tag symbol whose background color is set to gray and the text is "purchase product type quantity "; add a textbox symbol whose initial value is set to 2, shortly referred to as a purchase product type quantity textbox symbol; adding a stack layout symbol whose width value is set to 50; adding a button symbol whose text content attribute symbol is set to "business configuration", shortly referred to as a business configuration button symbol;
the software interaction graph receives and responds to the command from the actual software modeling environment to add a card symbol composed of three card pages for the business management root layout symbol;
in the foregoing steps, selecting from the card symbols a first card page shortly referred to as a production management card page, whose page name is changed into "production management"; adding, as a root display operator symbol of the production management card page, a free layout symbol which is shortly referred to as the production management card page root display operator symbol; adding a component interaction symbol for the production display function symbol based on the production management SCGL software component class symbol as a child interaction symbol of the production management card page root display operator symbol;
in the foregoing steps, selecting from the card symbols a second card page shortly referred to as a production management card page for the convenience of describing, whose page name is changed into "purchase management"; adding, as a root display operator symbol of the purchase management card page, a free layout symbol which is shortly referred to as the purchase management card page root display operator symbol for the convenience of describing; adding a component interaction symbol based on the purchase display function symbol of the purchase management CGGL software component class symbol as a child interaction symbol of the purchase management card page root display operator symbol;
in the foregoing steps, selecting from the card symbol a third card page shortly referred to as a sales management card page for the convenience of describing, whose page name is changed into "sales management"; adding, as a root display operator symbol of the sales management card page, a free layout symbol which is shortly referred to as the sales management card page root display operator symbol the convenience of describing; adding a component interaction symbol based on the sales display function symbol of the sales management XSGL software component class symbol as a child interaction symbol of the sales management card page root display operator symbol.

So far, the business display interaction view is accomplished.

### Sales display interaction view

As shown in Fig. 20, the construction procedure of the sales display interaction view is similar to that of "business display interaction view" and the content thereof is as follows:
creating, as a template of the sales display interaction view, a type template which is shortly referred to as the sales type template and contains an instance group layout symbol and an instance template, wherein the instance template is a display template, referred to as a sales instance template, for an instance of the sales management XSGL software component class symbol and the instance group layout symbol as a container is a stack layout symbol, referred to as a sales instance group layout symbol, responsible for the display layout between all instances of the sales management XSGL software component class symbol, where the stack direction of the sales instance group layout symbol is set to the longitudinal direction as a default;
adding, in the sales instance template, a stack layout symbol which is referred to as a sales instance stack layout symbol whose layout direction is set to the horizontal direction;
adding, in the sales instance stack layout symbol, a stack layout symbol which is referred to as a sales product name stack layout symbol; the software interaction graph receives and responds to the command from the actual software modeling environment to successively accomplish the following operations: setting the layout direction of the sales product name stack layout symbol to the horizontal direction; adding, in the sales product name stack layout symbol, a tag symbol whose text content is set to "sales products" and which is shortly referred to as the sales product name tag symbol; adding, in the sales product name stack layout symbol, a tag symbol whose text content is set to "1" and which is shortly referred to as the sales serial number tag symbol;
adding, in the sales instance stack layout symbol, a stack layout symbol which is referred to as a sales data stack layout symbol whose layout direction is set to the longitudinal direction as a default;
adding, in the sales data stack layout symbol, a stack layout symbol which is shortly referred to as the sales contract quantity stack layout symbol whose layout direction is set to the horizontal direction; adding, in the sales contract quantity stack layout symbol, a tag symbol whose text content is "contract quantity" and the background color is set to gray; adding, in the sales contract quantity stack layout symbol, a tag symbol whose text content attribute symbol is set to "0" and which is shortly referred to as the sales contract quantity display tag symbol;
adding, in the sales data stack layout symbol, a stack layout symbol which is referred to as a sales receipt quantity stack layout symbol whose layout direction is set to the horizontal direction; adding, in the sales receipt quantity stack layout symbol, a tag symbol whose text content is "receipt quantity" and the background color is set to gray; adding, in the sales receipt quantity stack layout symbol, a tag symbol whose text content attribute symbol is set to "0" and which is shortly referred to as the sales receipt quantity display tag symbol;
adding,, in the sales data stack layout symbol, a stack layout symbol which is referred to as a sales shipment quantity stack layout symbol whose layout direction is set to the horizontal direction; adding, in the sales shipment quantity stack layout symbol, a tag symbol whose text content is "shipment quantity" and the background color is set to gray; adding, in the sales shipment quantity stack layout symbol, a tag symbol whose text content attribute symbol is set to "0" and which is shortly referred to as the sales shipment quantity display tag symbol;
adding, in the sales data stack layout symbol, a stack layout symbol which is referred to as a total sales shipment quantity stack layout symbol whose layout direction is set to the horizontal direction; adding, in the total sales shipment quantity stack layout symbol, a tag symbol whose text content is "total shipment quantity" and the background color is set to gray; adding, in the total sales shipment quantity stack layout symbol, a tag symbol whose text content attribute symbol is set to "0" and which is shortly referred to as the total sales shipment quantity display tag symbol; and
adding, in the sales instance stack layout symbol, a component interaction symbol based on the sales display function symbol of the distributed sales product FXP software component class symbol and adding, in the sales instance stack layout symbol, a component interaction symbol based on the sales display function symbol of the direct sales product FXP software component class symbol.

### Production display interaction view

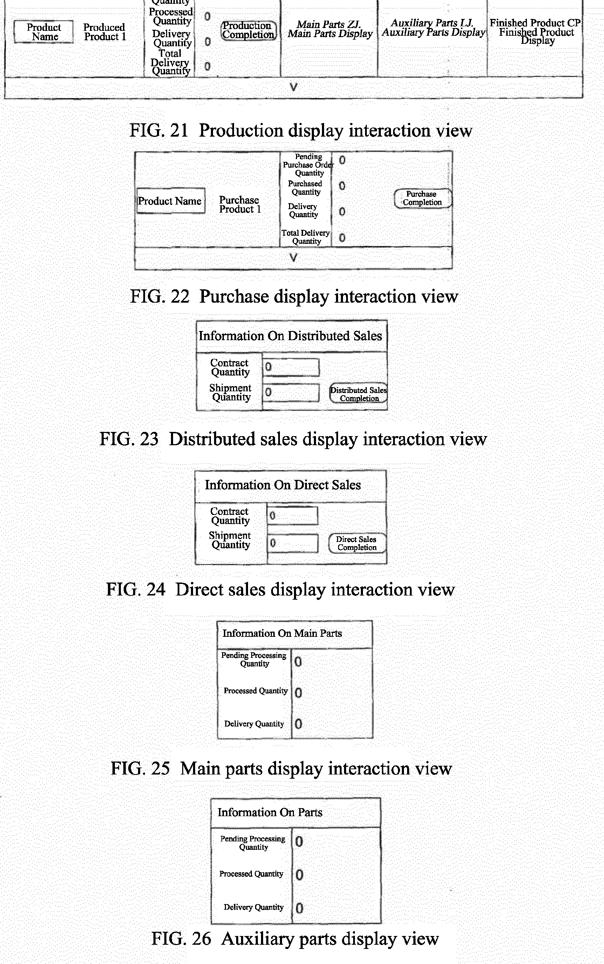

As shown in Fig. 21, the construction procedure of the production display interaction view is similar to that of "business management YWGL interface view" and the content thereof is as follows:
creating, as a template of the production display interaction view, a type template which is shortly referred to as the production type template and contains an instance group layout symbol and an instance template, wherein the instance template is a display template, referred to as a production instance template, for an instance of the production management SCGL software component class symbol and the instance group layout symbol as a container is a stack layout symbol, referred to as a production instance group layout symbol, responsible for the display layout between all instances of the production management SCGL software component class symbol, where the stack direction of the production instance group layout symbol is set to the longitudinal direction as a default;
adding, in the production instance template, a stack layout symbol which is referred to as a production instance stack layout symbol whose layout direction is set to the horizontal direction;
adding, in the production instance stack layout symbol, a stack layout symbol which is referred to as a produced product name stack layout symbol; the software interaction graph receives and responds to the command from the actual software modeling environment to successively accomplish the following operations: setting the layout direction of the produced product name stack layout symbol to the horizontal direction; adding, in the produced product name stack layout symbol, a tag symbol whose text content is set to "produced products" and which is shortly referred to as the produced product name tag symbol; adding, in the produced product name stack layout symbol, a tag symbol whose text content is set to "1" and which is shortly referred to as the produced product serial number tag symbol;
adding, in the production instance stack layout symbol, a stack layout symbol which is referred to as a production data stack layout symbol whose layout direction is set to the longitudinal direction as a default;
adding, in the production data stack layout symbol, a stack layout symbol which is shortly referred to as the production order quantity stack layout symbol whose layout direction is set to the horizontal direction; adding, in the production order quantity stack layout symbol, a tag symbol whose text content is "order quantity" and the background color is set to gray; adding, in the production order quantity stack layout symbol, a tag symbol whose text content attribute symbol is set to "0" and which is shortly referred to as the production order quantity display tag symbol;
adding, in the production data stack layout symbol, a stack layout symbol which is referred to as a production completion quantity stack layout symbol whose layout direction is set to the horizontal direction; adding, in the production completion quantity stack layout symbol, a tag symbol whose text content is "processed quantity" and the background color is set to gray; adding, in the production completion quantity stack layout symbol, a tag symbol whose text content attribute symbol is set to "0" and which is referred to as a production completion quantity display tag symbol;
adding, in the production data stack layout symbol, a stack layout symbol which is referred to as a production delivery quantity stack layout symbol whose layout direction is set to the horizontal direction; adding, in the production delivery quantity stack layout symbol, a tag symbol whose text content is "delivery quantity" and the background color is set to gray; adding, in the production delivery quantity stack layout symbol, a tag symbol whose text content attribute symbol is set to "0" and which is referred to as a production delivery quantity display tag symbol for the convenience of describing;
adding, in the production data stack layout symbol, a stack layout symbol which is referred to as a production total delivery quantity stack layout symbol whose layout direction is set to the horizontal direction; adding, in the production total delivery quantity stack layout symbol, a tag symbol whose text content is "total delivery quantity" and the background color is set to gray; adding, in the production total delivery quantity stack layout symbol, a tag symbol whose text content attribute symbol is set to "0" and which is referred to as a production total delivery quantity display tag symbol for the convenience of describing;
adding, in the production instance layout symbol, a button symbol which is shortly referred to as the production completion button symbol whose content attribute symbol is set to "production completion";
adding, in the production instance stack layout symbol, a component interaction symbol based on the main parts display function symbol of the main parts ZJ software component class symbol; adding, in the production instance stack layout symbol, a component interaction symbol based on the auxiliary parts display function symbol of the auxiliary parts LJ software component class symbol; and adding, in the production instance stack layout symbol, a component interaction symbol based on the finished product display function symbol of the finished product CP software component class symbol.

### Purchase display interaction view

As shown in Fig. 22, the construction procedure of the purchase display interaction view is similar to that of "business management YWGL interface view" and the content thereof is as follows:
creating, as a template of the purchase display interaction view, a type template which is shortly referred to as the purchase type template and contains an instance group layout symbol and an instance template, wherein the instance template is a display template, referred to as a purchase instance template, for an instance of the purchase management CGGL software component class symbol and the instance group layout symbol as a container is a stack layout symbol, referred to as a purchase instance group layout symbol, responsible for the display layout between all instances of the purchase management CGGL software component class symbol, where the stack direction of the purchase instance group layout symbol is set to the longitudinal direction as a default;
adding, in the purchase instance template, a stack layout symbol which is referred to as a purchase instance stack layout symbol whose layout direction is set to the horizontal direction;
adding, in the purchase instance stack layout symbol, a stack layout symbol which is referred to as a purchase product name stack layout symbol; the software interaction graph receives and responds to the command from the actual software modeling environment to successively accomplish the following operations: setting the layout direction of the purchase product name stack layout symbol to the horizontal direction; adding, in the purchase product name stack layout symbol, a tag symbol whose text content is set to "purchase products" and which is shortly referred to as the purchase product name tag symbol; adding, in the purchase product name stack layout symbol, a tag symbol whose text content is set to "1" and which is shortly referred to as the purchase product serial number tag symbol;
adding, in the purchase instance stack layout symbol, a stack layout symbol which is referred to as a purchase data stack layout symbol whose layout direction is set to the longitudinal direction as a default;
adding, in the purchase data stack layout symbol, a stack layout symbol which is shortly referred to as the pending purchase quantity stack layout symbol; adding, in the pending purchase quantity stack layout symbol, a tag symbol whose text content is "pending purchase quantity" and the background color is set to gray; adding, in the pending purchase quantity stack layout symbol, a tag symbol whose text content attribute symbol is set to "0" and which is shortly referred to as the pending purchase quantity display tag symbol;
adding, in the purchase data stack layout symbol, a stack layout symbol which is referred to as a purchased quantity stack layout symbol; adding, in the purchased quantity layout symbol, a tag symbol whose text content is "purchased quantity" and the background color is set to gray; adding, in the purchased quantity stack layout symbol, a tag symbol whose text content attribute symbol is set to "0" and which is referred to as a purchased quantity display tag symbol;
adding, in the purchase data stack layout symbol, a stack layout symbol which is referred to as a purchase delivery quantity stack layout symbol; adding, in the purchase delivery quantity layout symbol, a tag symbol whose text content is "delivery quantity" and the background color is set to gray; adding, in the purchase delivery quantity stack layout symbol, a tag symbol whose text content attribute symbol is set to "0" and which is referred to as a purchase delivery quantity display tag symbol for the convenience of describing;
adding, in the purchase data stack layout symbol, a stack layout symbol which is referred to as a purchase total delivery quantity stack layout symbol; adding, in the purchase total delivery quantity layout symbol, a tag symbol whose text content is "total delivery quantity" and the background color is set to gray; adding, in the purchase total delivery quantity stack layout symbol, a tag symbol whose text content attribute symbol is set to "0" and which is referred to as a purchase total delivery quantity display tag symbol for the convenience of describing;
adding, in the purchase instance layout symbol, a button symbol which is shortly referred to as the purchase completion button symbol whose content attribute symbol is set to "purchase completion".

### Distributed sales display interaction view

As shown in Fig. 23, the construction procedure of the distributed sales display interaction view is similar to that of "business management YWGL interface view" and the content thereof is as follows:
creating, as a root symbol, a stack layout symbol referred to as a distributed sales product root layout symbol; the software interaction graph setting the distributed sales product root layout symbol to the involved interaction symbol;
adding, in the distributed sales product root layout symbol, a tag symbol as a child interaction symbol; and setting the text content attribute symbol of the involved tag symbol to the word "information on the distributed sales";
adding, in the distributed sales product root layout symbol, a stack layout symbol which is shortly referred to as the distributed sales contract quantity stack layout symbol whose layout direction is set to the horizontal direction; adding, in the distributed sales contract quantity stack layout symbol, a tag symbol whose text content is "contract quantity" and the background color is set to gray; adding, in the distributed sales contract quantity stack layout symbol, a textbox symbol whose text content attribute symbol is set to "0" and which is shortly referred to as the distributed sales contract quantity textbox symbol;
adding, in the distributed sales product root layout symbol, a stack layout symbol which is shortly referred to as the distributed sales shipment quantity stack layout symbol whose layout direction is set to the horizontal direction; adding, in the distributed sales shipment quantity stack layout symbol, a tag symbol whose text content is "shipment quantity" and the background color is set to gray; adding, in the distributed sales shipment quantity stack layout symbol, a textbox symbol whose text content attribute symbol is set to "0" and which is shortly referred to as the distributed sales contract quantity textbox symbol; adding, in the distributed sales shipment quantity stack layout symbol, a button symbol whose text content attribute symbol is set to "distributed sales completion" and which is shortly referred to as the distributed sales completion button symbol.

### Direct sales display interaction view

As shown in Fig. 24, the construction procedure of the direct sales display interaction view is similar to that of "business management YWGL interface view" and the content thereof is as follows:
creating, as a root symbol, a stack layout symbol referred to as a direct sales product root layout symbol; the software interaction graph setting the direct sales product root layout symbol to the involved interaction symbol;
adding, in the direct sales product root layout symbol, a tag symbol as a child interaction symbol; and setting the text content attribute symbol of the involved tag symbol to the word "information on the direct sales";
adding, in the direct sales product root layout symbol, a stack layout symbol which is shortly referred to as the direct sales contract quantity stack layout symbol whose layout direction is set to the horizontal direction; adding, in the direct sales contract quantity stack layout symbol, a tag symbol whose text content is "contract quantity" and the background color is set to gray; adding, in the direct sales contract quantity stack layout symbol, a textbox symbol whose text content attribute symbol is set to "0" and which is shortly referred to as the direct sales contract quantity textbox symbol;
adding, in the direct sales product root layout symbol, a stack layout symbol which is shortly referred to as the direct sales shipment quantity stack layout symbol whose layout direction is set to the horizontal direction; adding, in the direct sales shipment quantity stack layout symbol, a tag symbol whose text content is "shipment quantity" and the background color is set to gray; adding, in the direct sales shipment quantity stack layout symbol, a textbox symbol whose text content attribute symbol is set to "0" and which is shortly referred to as the direct sales shipment quantity textbox symbol; adding, in the direct sales shipment quantity stack layout symbol, a button symbol whose text content attribute symbol is set to "direct sales completion" and which is shortly referred to as the direct sales completion button symbol.

### Main parts display interaction view

As shown in Fig. 25, the construction procedure of the main parts display interaction views similar to that of "business management YWGL interface view" and the content thereof is as follows:
creating, as a root symbol, a stack layout symbol referred to as a main parts root layout symbol; the software interaction graph setting the main parts root layout symbol to the involved interaction symbol;
adding, the main parts root layout symbol, a tag symbol as a child interaction symbol; and setting a text content attribute symbol of the involved tag symbol to the word "information on the main parts";
adding, in the main parts root layout symbol, a stack layout symbol which is shortly referred to as the main parts pending processing quantity stack layout symbol whose layout direction is set to the horizontal direction; adding, in the main parts pending processing quantity stack layout symbol, a tag symbol whose text content is "main parts pending processing quantity" and the background color is set to gray; adding, in the main parts pending processing quantity stack layout symbol, a tag symbol whose text content attribute symbol is set to "0" and which is shortly referred to as the main parts pending processing quantity display tag symbol;
adding, in the main parts root layout symbol, a stack layout symbol which is shortly referred to as the main parts processed quantity stack layout symbol whose layout direction is set to the horizontal direction; adding, in the main parts processed quantity stack layout symbol, a tag symbol whose text content is "processed quantity" and the background color is set to gray; adding, in the main parts processed quantity stack layout symbol, a tag symbol whose text content attribute symbol is set to "0" and which is shortly referred to as the main parts processed quantity display tag symbol;
adding, in the main parts root layout symbol, a stack layout symbol which is shortly referred to as the main parts delivery quantity stack layout symbol whose layout direction is set to the horizontal direction; adding, in the main parts delivery quantity stack layout symbol, a tag symbol whose text content is "delivery quantity" and the background color is set to gray; adding, in the main parts delivery quantity stack layout symbol, a tag symbol whose text content attribute symbol is set to "0" and which is shortly referred to as the main parts delivery quantity display tag symbol.

### Auxiliary parts display view

As shown in Fig. 26, the construction procedure of the auxiliary parts display view is similar to that of "business management YWGL interface view" and the content thereof is as follows:
creating, as a root symbol, a stack layout symbol referred to as an auxiliary parts root layout symbol; the software interaction graph setting the auxiliary parts root layout symbol as an involved interaction symbol;
adding, in the auxiliary parts root layout symbol, a tag symbol as a child interaction symbol; and setting a text content attribute symbol of the involved tag symbol as the word "information on the auxiliary parts";
adding, in the auxiliary parts root layout symbol, a stack layout symbol which is shortly referred to as the auxiliary parts pending processing quantity stack layout symbol whose layout direction is set to the horizontal direction; adding, in the auxiliary parts pending processing quantity stack layout symbol, a tag symbol whose text content is "main parts pending processing quantity" and the background color is set to gray; adding, in the auxiliary parts pending processing quantity stack layout symbol, a tag symbol whose text content attribute symbol is set to "0" and which is shortly referred to as the auxiliary parts pending processing quantity display tag symbol;
adding, in the auxiliary parts root layout symbol, a stack layout symbol which is shortly referred to as the auxiliary parts processed quantity stack layout symbol whose layout direction is set to the horizontal direction; adding, in the auxiliary parts processed quantity stack layout symbol, a tag symbol whose text content is "processed quantity" and the background color is set to gray; adding, in the auxiliary parts processed quantity stack layout symbol, a tag symbol whose text content attribute symbol is set to "0" and which is shortly referred to as the auxiliary parts processed quantity display tag symbol;
adding, in the auxiliary parts root layout symbol, a stack layout symbol which is shortly referred to as the auxiliary parts delivery quantity stack layout symbol whose layout direction is set to the horizontal direction; adding, in the auxiliary parts delivery quantity stack layout symbol, a tag symbol whose text content is "delivery quantity" and the background color is set to gray; adding, in the auxiliary parts delivery quantity stack layout symbol, a tag symbol whose text content attribute symbol is set to "0" and which is shortly referred to as the auxiliary parts delivery quantity display tag symbol.

### Finished product display interaction view

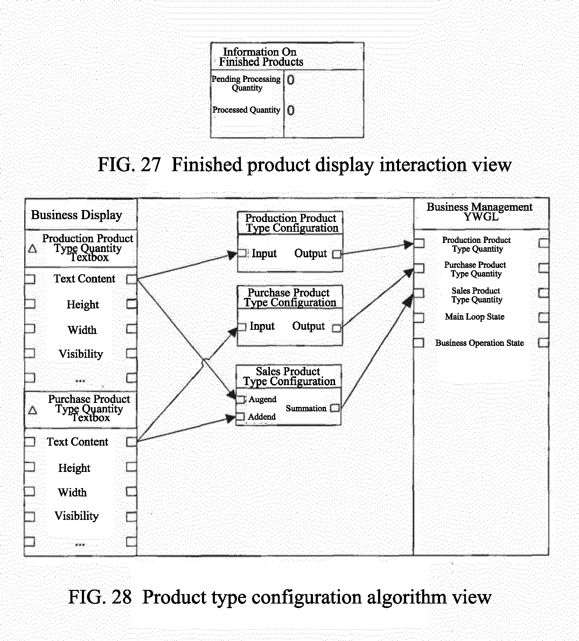

As shown in Fig. 27, the construction procedure of the finished product display interaction view is similar to that of "business management YWGL interface view" and the content thereof is as follows:
creating, as a root symbol, a stack layout symbol referred to as a finished product root layout symbol; and the software interaction graph setting the finished product root layout symbol to the involved interaction symbol;
adding, in the finished product root layout symbol, a tag symbol as a child interaction symbol; setting a text content attribute symbol of the involved tag symbol to the word "information on the finished product";
adding, in the finished product root layout symbol, a stack layout symbol which is shortly referred to as the finished product pending processing quantity stack layout symbol whose layout direction is set to the horizontal direction; adding, in the finished product pending processing quantity stack layout symbol, a tag symbol whose text content is "finished product pending processing quantity" and the background color is set to gray; adding, in the finished product pending processing quantity stack layout symbol, a tag symbol whose text content attribute symbol is set to "0" and which is shortly referred to as the finished product pending processing quantity display tag symbol;
adding, in the finished product root layout symbol, a stack layout symbol which is shortly referred to as the finished product processed quantity stack layout symbol whose layout direction is set to the horizontal direction; adding, in the finished product processed quantity stack layout symbol, a tag symbol whose text content is "processed quantity" and the background color is set to gray; adding, in the finished product processed quantity stack layout symbol, a tag symbol whose text content attribute symbol is set to "0" and which is shortly referred to as the finished product processed quantity display tag symbol.

### Constructing the software algorithm views

Next, the construction procedure of each software algorithm view will be described in detail.

### Product type configuration algorithm view

Fig. 28 schematically is the accomplished software algorithm view of the product type configuration function symbol of the business management YWGL software component class symbol whose construction procedure is as follows:
the software hierarchy graph receives and responds to the command from the actual software modeling environment to set the business management YWGL software component class symbol to the involved software component class symbol; the software interface graph receives and responds to the command from the actual software modeling environment to set the product type configuration function symbol to the involved interaction symbol, wherein the software algorithm view for implementing the product type configuration function symbol is shortly referred to as the product type configuration algorithm view in accordance with the function symbol name and software algorithm views for the subsequent other function symbols may be deduced by analogy, which will not be repeated below;
in the foregoing steps, adding an assignment operator symbol shortly referred to as a production product type configuration operator symbol which has an input attribute symbol and an output attribute symbol; creating an assignment symbol from the text content attribute symbol of the production product type quantity textbox symbol in the business display interaction view to the input attribute symbol of production product type configuration operator symbol; creating an assignment symbol from the output attribute symbol of production product type configuration operator symbol to the production product type quantity attribute symbol of the business management YWGL software component class symbol;
in the foregoing steps, adding an assignment operator symbol shortly referred to as a purchase product type configuration operator symbol which has an input attribute symbol and an output attribute symbol; creating an assignment symbol from the text content attribute symbol of the purchase product type quantity textbox symbol in the business display interaction view to the input attribute symbol of the purchase product type configuration operator symbol; creating an assignment symbol from the output attribute symbol of the purchase product type configuration operator symbol to the purchase product type quantity attribute symbol of the business management YWGL software component class symbol;
in the foregoing steps, adding an addition operator symbol shortly referred to as a sales product type configuration operator symbol; creating an assignment symbol from the text content attribute symbol of the production product type quantity textbox symbol to the augend attribute symbol of the sales product type configuration operator symbol; creating an assignment symbol from the text content attribute symbol of the purchase product type quantity textbox symbol to the addend attribute symbol of the sales product type configuration operator symbol; creating an assignment symbol from the summation attribute symbol of the sales product type configuration operator symbol to the sales product type quantity attribute symbol of the business management YWGL software component class symbol;

So far, the product type configuration algorithm view is accomplished.

### Sales update algorithm view

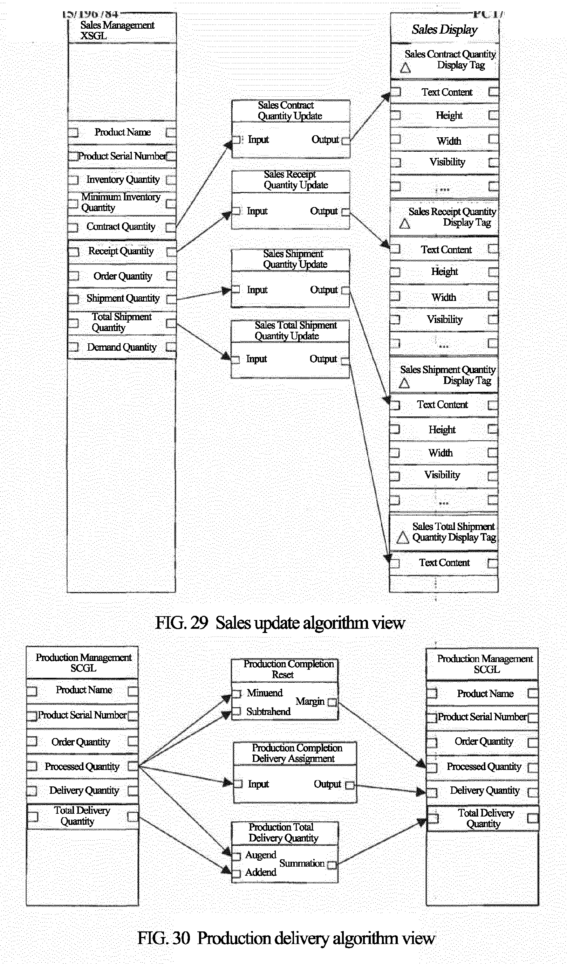

As shown in Fig. 29, the construction procedure of the sales update algorithm view is similar to that of "product type configuration algorithm view" and the content thereof is as follows:
an assignment operator symbol which is shortly referred to as the sales contract quantity update operator symbol which has the following assignments: from the input attribute symbol of the contract quantity attribute symbol of the sales management XSGL software component class symbol to the sales contract quantity update operator symbol; and from the output attribute symbol of the sales contract quantity update operator symbol to the text content attribute symbol of the sales contract quantity display tag symbol in the sales display interaction view;
an assignment operator symbol which is shortly referred to as the sales receipt quantity update operator symbol which has the following assignments: from the receipt quantity attribute symbol of the sales management XSGL software component class symbol to the input attribute symbol of the sales receipt quantity update operator symbol; and from the output attribute symbol of the sales receipt quantity update operator symbol to the text content attribute symbol of the sales receipt quantity display tag symbol in the sales display interaction view;
an assignment operator symbol which is shortly referred to as the sales shipment quantity update operator symbol which has the following assignments: from the shipment quantity attribute symbol of the sales management XSGL software component class symbol to the input attribute symbol of the sales shipment quantity update operator symbol; and from the output attribute symbol of the sales shipment quantity update operator symbol to the text content attribute symbol of the sales shipment quantity display tag symbol in the sales display interaction view;
an assignment operator symbol which is shortly referred to as the sales total shipment quantity update operator symbol which has the following assignments: from the total shipment quantity attribute symbol of the sales management XSGL software component class symbol to the input attribute symbol of the sales total shipment quantity update operator symbol; and from the output attribute symbol of the sales total shipment quantity update operator symbol to the text content attribute symbol of the sales total shipment quantity display tag symbol in the sales display interaction view.

### Production delivery algorithm view

As shown in Fig. 30, the construction procedure of the production delivery algorithm view is similar to that of "product type configuration algorithm view" and the content thereof is as follows:
an assignment operator symbol which is shortly referred to as the production completion delivery assignment operator symbol which has the following assignments: from the processed quantity attribute symbol of the production management SCGL software component class symbol to the input attribute symbol of the production completion delivery assignment operator symbol; and from the output attribute symbol of the production completion delivery assignment operator symbol to the delivery quantity attribute symbol of the production management SCGL software component class symbol;
an addition operator symbol which is shortly referred to as the production total delivery quantity operator symbol which has the following assignments: from the processed quantity attribute symbol of the production management SCGL software component class symbol to the augend attribute symbol of the production total delivery quantity operator symbol; from the total delivery quantity attribute symbol of the production management SCGL software component class symbol to the addend attribute symbol of the production total delivery quantity operator symbol; and from the summation attribute symbol of the production total delivery quantity operator symbol to the total delivery quantity attribute symbol of the production management SCGL software component class symbol;
an subtraction operator symbol which is shortly referred to as the production completion reset operator symbol which has the following assignments: from the processed quantity attribute symbol of the production management SCGL software component class symbol to the minuend attribute symbol of the production completion reset operator symbol; from the processed quantity attribute symbol of the production management SCGL software component class symbol to the subtrahend attribute symbol of the production completion reset operator symbol; and from the margin attribute symbol of the production completion reset operator symbol to the processed quantity attribute symbol of the production management SCGL software component class symbol;

### Production update algorithm view

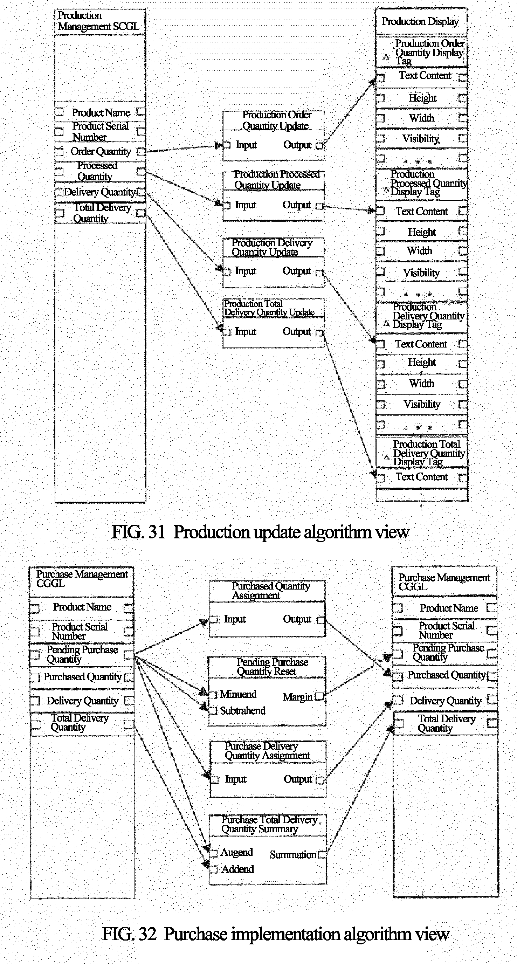

As shown in Fig. 31, the construction procedure of the production update algorithm view is similar to that of "product type configuration algorithm view" and the content thereof is as follows:
an assignment operator symbol which is shortly referred to as the production order quantity update operator symbol which has the following assignments: from the order quantity attribute symbol of the production management SCGL software component class symbol to the input attribute symbol of the production order quantity update operator symbol; and from the output attribute symbol of the production order quantity update operator symbol to the text content attribute symbol of the production order quantity display tag symbol in the production display interaction view;
an assignment operator symbol which is shortly referred to as the production completion quantity update operator symbol which has the following assignments: from the processed quantity attribute symbol of the production management SCGL software component class symbol to the input attribute symbol of the production completion quantity update operator symbol; and from the output attribute symbol of the production completion quantity update operator symbol to the text content attribute symbol of the production completion quantity display tag symbol in the production display interaction view;
an assignment operator symbol which is shortly referred to as the production delivery quantity update operator symbol which has the following assignments: from the delivery quantity attribute symbol of the production management SCGL software component class symbol to the input attribute symbol of the production delivery quantity update operator symbol; and from the output attribute symbol of the production delivery quantity update operator symbol to the text content attribute symbol of the production delivery quantity display tag symbol in the production display interaction view;
an assignment operator symbol which is shortly referred to as the production total delivery quantity update operator symbol which has the following assignments: from the total delivery quantity attribute symbol of the production management SCGL software component class symbol to the input attribute symbol of the production total delivery quantity update operator symbol; and from the output attribute symbol of the production total delivery quantity update operator symbol to the text content attribute symbol of the production total delivery quantity display tag symbol in the production display interaction view.

### Purchase implementation algorithm view

As shown in Fig. 32, the construction procedure of the purchase implementation algorithm view is similar to that of "product type configuration algorithm view" and the content thereof is as follows:
an assignment operator symbol which is shortly referred to as the purchased quantity assignment operator symbol which has the following assignments: from the pending purchase quantity attribute symbol of the purchase management CGGL software component class symbol to the input attribute symbol of the purchased quantity assignment operator symbol; and from the output attribute symbol of the purchased quantity assignment operator symbol to the purchased quantity attribute symbol of the purchase management CGGL software component class symbol;
an assignment operator symbol which is shortly referred to as the purchase delivery quantity assignment operator symbol which has the following assignments: from the pending purchase quantity attribute symbol of the purchase management CGGL software component class symbol to the input attribute symbol of the purchase delivery quantity assignment operator symbol; and from the output attribute symbol of the purchase delivery quantity assignment operator symbol to the delivery quantity attribute symbol of the purchase management CGGL software component class symbol;
an addition operator symbol which is shortly referred to as the purchase total delivery quantity summary operator symbol which has the following assignments: from the pending purchase quantity attribute symbol of the purchase management CGGL software component class symbol to the augend attribute symbol of the purchase total delivery quantity summary operator symbol; from the total delivery quantity attribute symbol of the purchase management CGGL software component class symbol to the addend attribute symbol of the purchase total delivery quantity summary operator symbol; and from the summation attribute symbol of the purchase total delivery quantity summary operator symbol to the total delivery quantity of the purchase management CGGL software component class symbol;
an subtraction operator symbol which is shortly referred to as the pending purchase quantity reset operator symbol which has the following assignments: from the pending purchase quantity attribute symbol of the purchase management CGGL software component class symbol to the minuend attribute symbol of the pending purchase quantity reset operator symbol; from the pending purchase quantity attribute symbol of the purchase management CGGL software component class symbol to the subtrahend attribute symbol of the pending purchase quantity reset operator symbol; and from the output attribute symbol of the pending purchase quantity reset operator symbol to the pending purchase quantity attribute symbol of the purchase management CGGL software component class symbol.

### Purchase update algorithm view

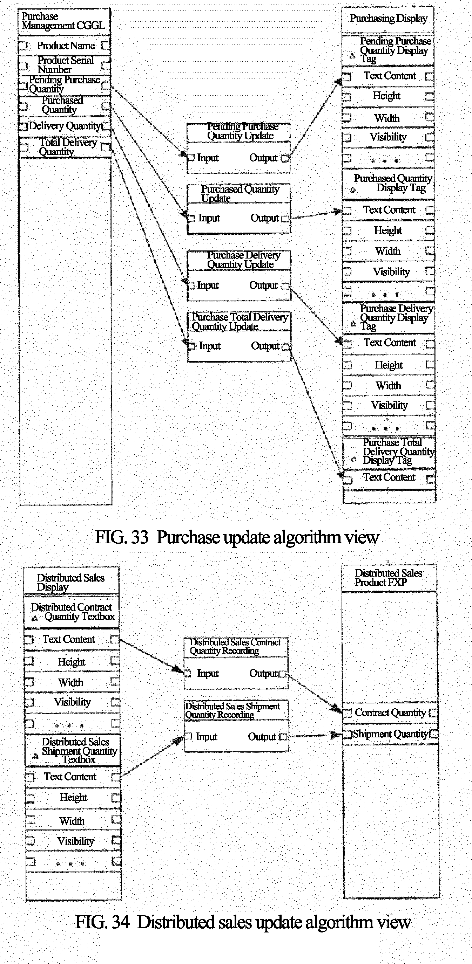

As shown in Fig. 33, the construction procedure of the purchase update algorithm view is similar to that of "product type configuration algorithm view" and the content thereof is as follows:
an assignment operator symbol which is shortly referred to as the pending purchase quantity update operator symbol which has the following assignments: from the pending purchase quantity attribute symbol of the purchase management CGGL software component class symbol to the input attribute symbol of the pending purchase quantity update operator symbol; and from the output attribute symbol of the pending purchase quantity update operator symbol to the text content attribute symbol of the pending purchase quantity display tag symbol in the purchase display interaction view;
an assignment operator symbol which is shortly referred to as the purchased quantity update operator symbol which has the following assignments: from the purchased quantity attribute symbol of the purchase management CGGL software component class symbol to the input attribute symbol of the purchased quantity update operator symbol; and from the output attribute symbol of the purchased quantity update operator symbol to the text content attribute symbol of the purchased quantity display tag symbol in the purchase display interaction view;
an assignment operator symbol which is shortly referred to as the purchase delivery quantity update operator symbol which has the following assignments: from the delivery quantity attribute symbol of the purchase management CGGL software component class symbol to the input attribute symbol of the purchase delivery quantity update operator symbol; and from the output attribute symbol of the purchase delivery quantity update operator symbol to the text content attribute symbol of the purchase delivery quantity display tag symbol in the purchase display interaction view;
an assignment operator symbol which is shortly referred to as the purchase total delivery quantity update operator symbol which has the following assignments: from the total delivery quantity attribute symbol of the purchase management CGGL software component class symbol to the input attribute symbol of the purchase total delivery quantity update operator symbol; and from the output attribute symbol of the purchase total delivery quantity update operator symbol to the text content attribute symbol of the purchase total delivery quantity display tag symbol in the purchase display interaction view;

### Distributed sales update algorithm view

As shown in Fig. 34, the construction procedure of the distributed sales update algorithm view is similar to that of "product type configuration algorithm view" and the content thereof is as follows:
an assignment operator symbol which is shortly referred to as the distributed sales contract quantity recording operator symbol which has the following assignments: from the text content attribute symbol of the distributed sales contract quantity textbox symbol in the distributed sales display interaction view to the input attribute symbol of the distributed sales contract quantity recording operator symbol; and from the output attribute symbol of the distributed sales contract quantity recording operator symbol to the contract quantity attribute symbol of the distributed sales product FXP software component class symbol;
an assignment operator symbol which is shortly referred to as the distributed sales shipment quantity recording operator symbol which has the following assignments: from the text content attribute symbol of the distributed sales shipment quantity textbox symbol in the distributed sales display interaction view to the input attribute symbol of the distributed sales shipment quantity recording operator symbol; and from the output attribute symbol of the distributed sales shipment quantity recording operator symbol to the shipment quantity attribute symbol of the distributed sales product FXP software component class symbol.

### Direct sales update algorithm view

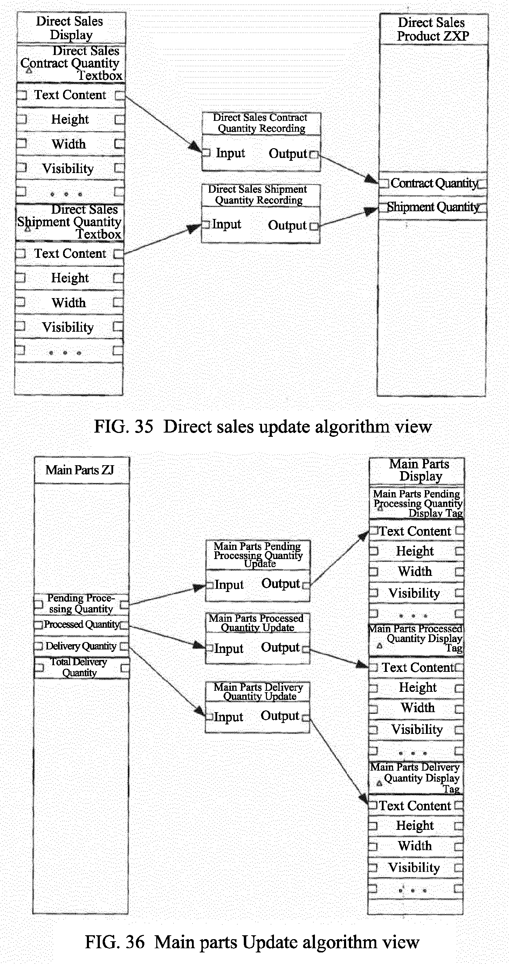

As shown in Fig. 35, the construction procedure of the direct sales update algorithm view is similar to that of "product type configuration algorithm view" and the content thereof is as follows:
an assignment operator symbol which is shortly referred to as the direct sales contract quantity recording operator symbol which has the following assignments: from the text content attribute symbol of the direct sales contract quantity textbox symbol in the direct sales display interaction view to the input attribute symbol of the direct sales contract quantity recording operator symbol; and from the output attribute symbol of the direct sales contract quantity recording operator symbol to the contract quantity attribute symbol of direct sales product ZXP software component class symbol;
an assignment operator symbol which is shortly referred to as the direct sales shipment quantity recording operator symbol which has the following assignments: from the text content attribute symbol of the direct sales shipment quantity textbox symbol in the direct sales display interaction view to the input attribute symbol of the direct sales shipment quantity recording operator symbol; and from the output attribute symbol of the direct sales shipment quantity recording operator symbol to the shipment quantity attribute symbol of the direct sales product ZXP software component class symbol.

### Main parts update algorithm view

As shown in Fig. 36, the construction procedure of the main parts update algorithm view is similar to that of "product type configuration algorithm view" and the content thereof is as follows:
an assignment operator symbol which is shortly referred to as the main parts pending processing quantity update operator symbol which has the following assignments: from the main parts pending processing quantity attribute symbol of the main parts ZJ software component class symbol to the input attribute symbol of the main parts pending processing quantity update operator symbol; and from the output attribute symbol of the main parts pending processing quantity update operator symbol to the text content attribute symbol of the main parts pending processing quantity display tag symbol in the main parts display interaction view;
an assignment operator symbol which is shortly referred to as the main parts processed quantity update operator symbol which has the following assignments: from the processed quantity attribute symbol of the main parts ZJ software component class symbol to the input attribute symbol of the main parts processed quantity update operator symbol; and from the output attribute symbol of the main parts processed quantity update operator symbol to the text content attribute symbol of the main parts processed quantity display tag symbol in the main parts display interaction view;
an assignment operator symbol which is shortly referred to as the main parts delivery quantity update operator symbol which has the following assignments: from the delivery quantity attribute symbol of the main parts ZJ software component class symbol to the input attribute symbol of the main parts delivery quantity update operator symbol; and from the output attribute symbol of the main parts delivery quantity update operator symbol to the text content attribute symbol of the main parts delivery quantity display tag symbol in the main parts display interaction view.

### Auxiliary parts update algorithm view

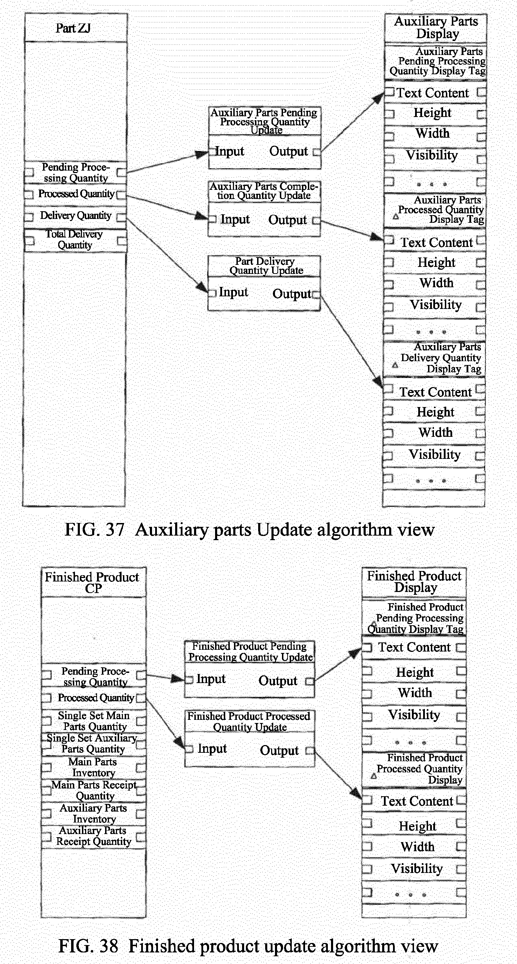

As shown in Fig. 37, the construction procedure of the auxiliary parts update algorithm view is similar to that of "product type configuration algorithm view" and the content thereof is as follows:
an assignment operator symbol which is shortly referred to as the auxiliary parts pending processing quantity update operator symbol which has the following assignments: from the auxiliary parts pending processing quantity attribute symbol of the auxiliary parts LJ software component class symbol to the input attribute symbol of the auxiliary parts pending processing quantity update operator symbol; and from the output attribute symbol of the auxiliary parts pending processing quantity update operator symbol to the text content attribute symbol of the auxiliary parts pending processing quantity display tag symbol in the auxiliary parts display view;
an assignment operator symbol which is shortly referred to as the auxiliary parts processed quantity update operator symbol which has the following assignments: from the processed quantity attribute symbol of the auxiliary parts LJ software component class symbol to the input attribute symbol of the auxiliary parts processed quantity update operator symbol; and from the output attribute symbol of the auxiliary parts processed quantity update operator symbol to the text content attribute symbol of the auxiliary parts processed quantity display tag symbol in the auxiliary parts display view;
an assignment operator symbol which is shortly referred to as the auxiliary parts delivery quantity update operator symbol which has the following assignments: from the delivery quantity attribute symbol of the auxiliary parts LJ software component class symbol to the input attribute symbol of the auxiliary parts delivery quantity update operator symbol; and from the output attribute symbol of the auxiliary parts delivery quantity update operator symbol to the text content attribute symbol of the auxiliary parts delivery quantity display tag symbol in the auxiliary parts display view.

### Finished product update algorithm view

As shown in Fig. 38, the construction procedure of the finished product update algorithm view is similar to that of "product type configuration algorithm view" and the content thereof is as follows:
an assignment operator symbol which is shortly referred to as the finished product pending processing quantity update operator symbol which has the following assignments: from the finished product pending processing quantity attribute symbol of the finished product CP software component class symbol to the input attribute symbol of the finished product pending processing quantity update operator symbol; and from the output attribute symbol of the finished product pending processing quantity update operator symbol to the text content attribute symbol of the finished product pending processing quantity display tag symbol in the finished product display interaction view;
an assignment operator symbol which is shortly referred to as the finished product processed quantity update operator symbol which has the following assignments: from the processed quantity attribute symbol of the finished product CP software component class symbol to the input attribute symbol of the finished product processed quantity update operator symbol; and from the output attribute symbol of the finished product processed quantity update operator symbol to the text content attribute symbol of the finished product processed quantity display tag symbol in the finished product display interaction view;

### Main parts processing algorithm view

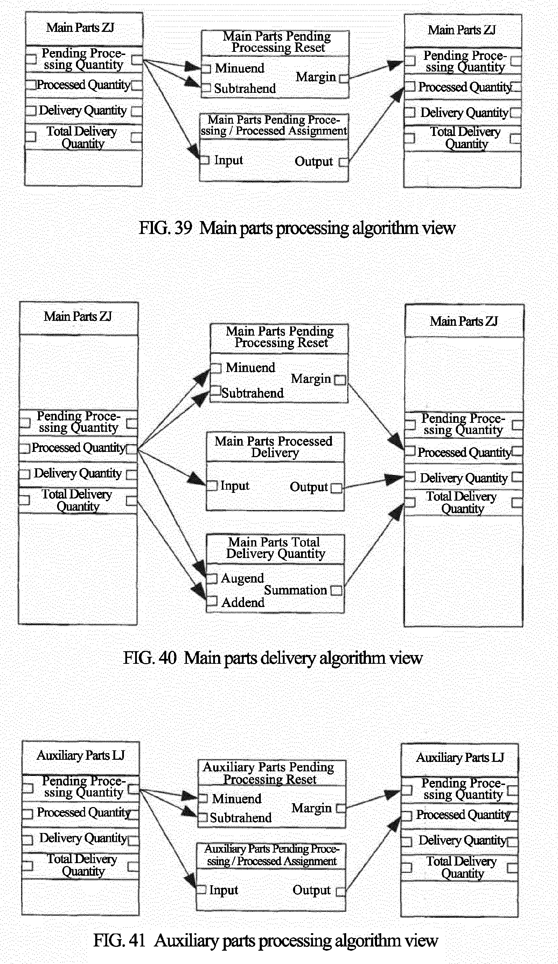

As shown in Fig. 39, the construction procedure of the main parts processing algorithm view is similar to that of "product type configuration algorithm view" and the content thereof is as follows:
an assignment operator symbol which is shortly referred to as the main parts pending processing / processed assignment operator symbol which has the following assignments: from the main parts pending processing quantity attribute symbol of the main parts ZJ software component class symbol to the input attribute symbol of the main parts pending processing / processed assignment operator symbol; and from the output attribute symbol of the main parts pending processing / processed assignment operator symbol to the processed quantity attribute symbol of the main parts ZJ software component class symbol;
a subtraction operator symbol which is shortly referred to as the main parts pending processing reset operator symbol which has the following assignments: from the main parts pending processing quantity attribute symbol of the main parts ZJ software component class symbol to the minuend attribute symbol of the main parts pending processing reset operator symbol; from the main parts pending processing quantity attribute symbol of the main parts ZJ software component class symbol to the subtrahend attribute symbol of the main parts pending processing reset operator symbol; and from the margin output of the main parts pending processing reset operator symbol to the pending processing quantity attribute symbol of the main parts ZJ software component class symbol.

### Main parts delivery algorithm view

As shown in Fig. 40, the construction procedure of the main parts delivery algorithm view is similar to that of "product type configuration algorithm view" and the content thereof is as follows:
an assignment operator symbol which is shortly referred to as the main parts processed delivery operator symbol which has the following assignments: from the processed quantity attribute symbol of the main parts ZJ software component class symbol to the input attribute symbol of the main parts processed delivery operator symbol; and from the output attribute symbol of the main parts processed delivery operator symbol to the delivery quantity attribute symbol of the main parts ZJ software component class symbol;
an addition operator symbol which is shortly referred to as the main parts total delivery quantity operator symbol which has the following assignments: from the processed quantity attribute symbol of the main parts ZJ software component class symbol to the augend attribute symbol of the main parts total delivery quantity operator symbol; from the total delivery quantity attribute symbol of the main parts ZJ software component class symbol to the addend attribute symbol of the main parts total delivery quantity operator symbol; and from the summation attribute symbol of the main parts total delivery quantity operator symbol to the total delivery quantity attribute symbol of the main parts ZJ software component class symbol;
a subtraction operator symbol which is shortly referred to as the main parts processed reset operator symbol which has the following assignments: from the processed quantity attribute symbol of the main parts ZJ software component class symbol to the minuend attribute symbol of the main parts processed reset operator symbol; from the processed quantity attribute symbol of the main parts ZJ software component class symbol to the subtrahend attribute symbol of the main parts processed reset operator symbol; and from the margin attribute symbol of the main parts processed reset operator symbol to the processed quantity attribute symbol of the main parts ZJ software component class symbol.

### Auxiliary parts processing algorithm view

As shown in Fig. 41, the construction procedure of the auxiliary parts processing algorithm view is similar to that of "product type configuration algorithm view" and the content thereof is as follows:
an assignment operator symbol which is shortly referred to as the auxiliary parts pending processing / processed assignment operator symbol which has the following assignments: from the auxiliary parts pending processing quantity attribute symbol of the auxiliary parts LJ software component class symbol to the input attribute symbol of the auxiliary parts pending processing / processed assignment operator symbol; and from the output attribute symbol of the auxiliary parts pending processing / processed assignment operator symbol to the processed quantity attribute symbol of the auxiliary parts ZJ software component class symbol;
a subtraction operator symbol which is shortly referred to as the auxiliary parts pending processing reset operator symbol which has the following assignments: from the auxiliary parts pending processing quantity attribute symbol of the auxiliary parts LJ software component class symbol to the minuend attribute symbol of the auxiliary parts pending processing reset operator symbol; from the auxiliary parts pending processing quantity attribute symbol of the auxiliary parts LJ software component class symbol to the subtrahend attribute symbol of the auxiliary parts pending processing reset operator symbol; and from the margin output of the auxiliary parts pending processing reset operator symbol to the auxiliary parts pending processing quantity attribute symbol of the auxiliary parts LJ software component class symbol.

### Auxiliary parts delivery algorithm view

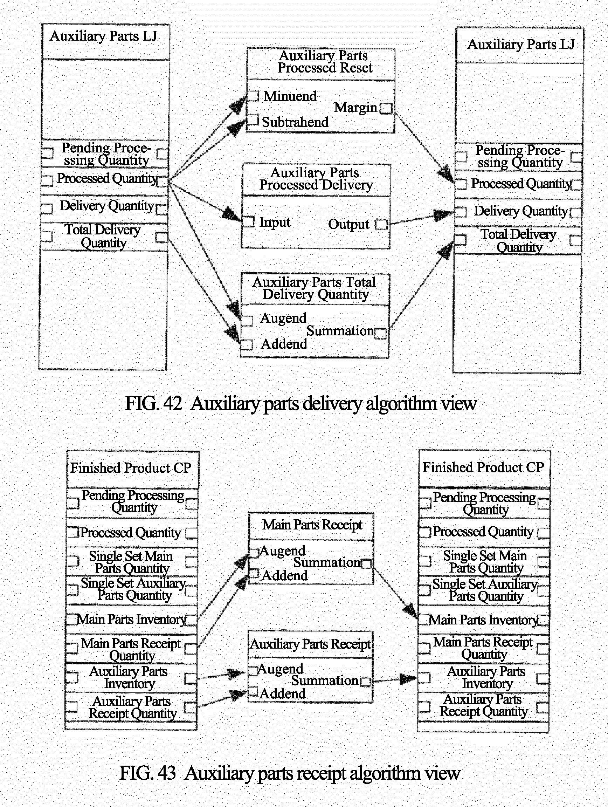

As shown in Fig. 42, the construction procedure of the auxiliary parts delivery algorithm view is similar to that of "product type configuration algorithm view" and the content thereof is as follows:
an assignment operator symbol which is shortly referred to as the auxiliary parts processed delivery operator symbol which has the following assignments: from the processed quantity attribute symbol of the auxiliary parts LJ software component class symbol to the input attribute symbol of the auxiliary parts processed delivery operator symbol; and from the output attribute symbol of the auxiliary parts processed delivery operator symbol to the delivery quantity attribute symbol of the auxiliary parts LJ software component class symbol;
an addition operator symbol which is shortly referred to as the auxiliary parts total delivery quantity operator symbol which has the following assignments: from the processed quantity attribute symbol of the auxiliary parts LJ software component class symbol to the augend attribute symbol of the auxiliary parts total delivery quantity operator symbol; from the total delivery quantity attribute symbol of the auxiliary parts LJ software component class symbol to the addend attribute symbol of the auxiliary parts total delivery quantity operator symbol; and from the summation attribute symbol of the auxiliary parts total delivery quantity operator symbol to the total delivery quantity attribute symbol of the auxiliary parts LJ software component class symbol;
a subtraction operator symbol which is shortly referred to as the auxiliary parts processed reset operator symbol which has the following assignments: from the processed quantity attribute symbol of the auxiliary parts LJ software component class symbol to the minuend attribute symbol of the auxiliary parts processed reset operator symbol; from the processed quantity attribute symbol of the auxiliary parts LJ software component class symbol to the subtrahend attribute symbol of the auxiliary parts processed reset operator symbol; and from the margin attribute symbol of the auxiliary parts processed reset operator symbol to the processed quantity attribute symbol of the auxiliary parts LJ software component class symbol.

### Auxiliary parts receipt algorithm view

As shown in Fig. 43, the construction procedure of the auxiliary parts receipt algorithm view is similar to that of "product type configuration algorithm view" and the content thereof is as follows:
an addition operator symbol which is shortly referred to as the main parts receipt operator symbol has the following assignments: from the main parts inventory quantity attribute symbol of the involved software component class symbol to the augend attribute symbol of the main parts receipt operator symbol; from the main parts receipt quantity attribute symbol of the involved software component class symbol to the addend attribute symbol of the main parts receipt operator symbol; and from the summation attribute symbol of the main parts receipt operator symbol to the main parts inventory quantity attribute symbol of the finished product CP software component class symbol;
an addition operator symbol which is shortly referred to as the auxiliary parts receipt operator symbol has the following assignments: from the auxiliary parts inventory quantity attribute symbol of the involved software component class symbol to the augend attribute symbol of the auxiliary parts receipt operator symbol; from the auxiliary parts receipt quantity attribute symbol of the involved software component class symbol to the addend attribute symbol of the auxiliary parts receipt operator symbol; and from the summation attribute symbol of the auxiliary parts receipt operator symbol to the auxiliary parts inventory quantity attribute symbol of the finished product CP software component class symbol.

### Finished product assembly algorithm view

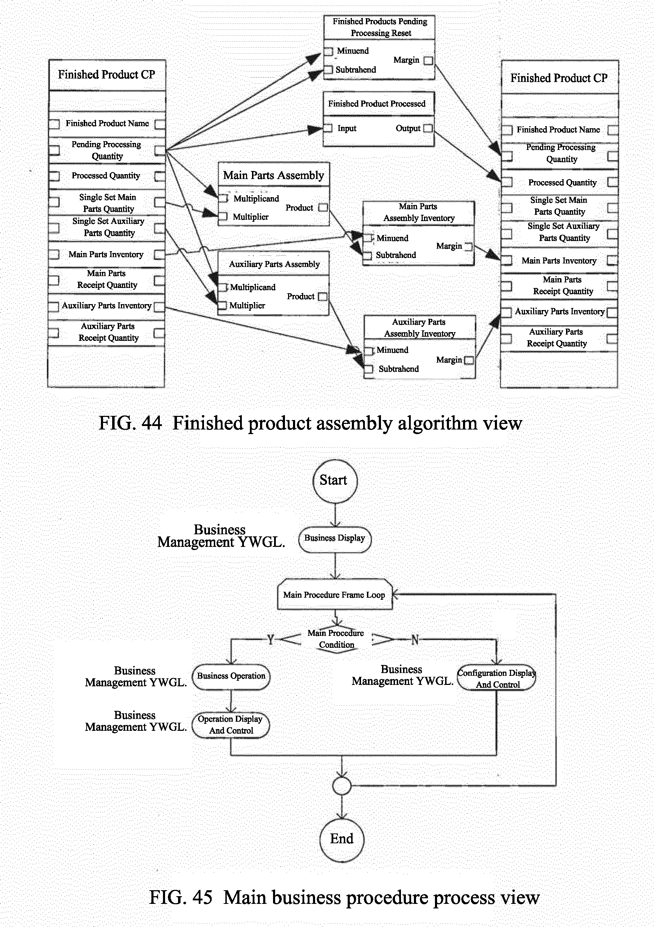

As shown in Fig. 44, the construction procedure of the finished product assembly algorithm view is similar to that of the "product type configuration algorithm view" and the content thereof is as follows:
a multiplication operator symbol which is shortly referred to as the main parts assembly operator symbol has the following assignments: from the pending processing quantity attribute symbol of the involved software component class symbol to the multiplicand input attribute symbol of the main parts assembly operator symbol; and from the single set main parts quantity attribute symbol of the involved software component class symbol to the multiplier input attribute symbol of the main parts assembly operator symbol;
a subtraction operator symbol which is shortly referred to as the main parts assembly inventory operator symbol has the following assignments: from the main parts inventory quantity attribute symbol of the finished product CP software component class symbol to the minuend attribute symbol of the main parts assembly inventory operator symbol; from the product output of the main parts assembly inventory operator symbol to the subtrahend attribute symbol of the main parts assembly inventory operator symbol; and from the margin output of the main parts assembly inventory operator symbol to the main parts inventory quantity attribute symbol of the finished product CP software component class symbol;
a multiplication operator symbol which is shortly referred to as the an auxiliary-parts assembly operator symbol has the following assignments: from the pending processing quantity attribute symbol of the involved software component class symbol to the multiplicand input attribute symbol of the auxiliary parts assembly operator symbol; and the single set auxiliary parts quantity attribute symbol of the involved software component class symbol to the multiplier input attribute symbol of the auxiliary parts assembly operator symbol;
a subtraction operator symbol which is shortly referred to as the auxiliary parts assembly inventory operator symbol has the following assignments: from the auxiliary parts inventory quantity attribute symbol of the finished product CP software component class symbol to the minuend attribute symbol of the auxiliary parts assembly inventory operator symbol; and from the product output of the auxiliary-parts assembly inventory operator symbol to the subtrahend attribute symbol of the auxiliary parts assembly inventory operator symbol; and from the margin output of the auxiliary parts assembly inventory operator symbol to the auxiliary parts inventory quantity attribute symbol of the finished product CP software component class symbol;
an assignment operator symbol which is shortly referred to as the finished product processed operator symbol has the following assignments: from the pending processing quantity attribute symbol of the finished product CP software component class symbol to the input attribute symbol of the finished product processed operator symbol; and from the output attribute symbol of the finished product processed operator symbol to the finished product CP software component class symbol' processed quantity attribute symbol;
a subtraction operator symbol which is shortly referred to as the finished product pending processing reset operator symbol has the following assignments: from the finished product CP software component class symbol' pending processing quantity attribute symbol to the minuend attribute symbol of the finished product pending processing operator symbol; from the pending processing quantity attribute symbol of the involved software component class symbol to the subtrahend attribute symbol of the finished product pending processing operator symbol; and from the margin output of the finished product pending processing operator symbol to the pending processing quantity attribute symbol of the finished product CP software component class symbol.

### Constructing software process views

Next, the construction procedure of each software process view will be described in detail.

### Main business procedure process view

Fig. 45 shows a completed main business procedure process view for the business management YWGL software component class symbol. It is constructed as follows:
the software hierarchy graph receives and responds to the command from the actual software modeling environment to set the business management YWGL software component class symbol as the involved software component class symbols;
the software interface graph receives and responds to the command from the actual software modeling environment to set the main business procedure function symbol as the involved function symbol, wherein, for the convenience of the description, the software process view of the main business procedure function symbol is shortly referred to as the main business procedure process view in accordance with the function symbol name and names of process views for the other function symbols may be deduced by analogy, which will not be repeated below; and wherein the software process graph constructs the main business procedure process view with an attribute process view as a default;
the software process graph first creates a sequential action symbol as the root action symbol for the main business procedure process view, wherein the sequential action symbol is an operator action symbol with sequential execution internal action symbol function symbol, has a start node and an end node, and may sequentially add other action symbols between the start node and the end node, and wherein, for the convenience of the description, the root action symbol is referred to as a main business procedure root action symbol in accordance with the name of the software process view; it should be noted that the software process graph creates a root action symbol for each software process view as a default, whose name of the root action symbol may be deduced by analogy and will not be repeated below;
the software process graph receives the command from the actual software modeling environment to add an action symbol based on a business display function symbol of the involved software component class symbol; for the convenience of the description, based on the name of function symbol on which the action symbol depends, the action symbol is shortly referred to as the business display action symbol and names for subsequent action symbols may be deduced by analogy, which will not be repeated below; and the software process graph adds a business display action symbol in the main business procedure root action symbol in response to the foregoing command;
the software process graph receives the command from the actual software modeling environment to add a frame loop action symbol; and the software process graph adds a frame loop action symbol in the main business procedure root action symbol, wherein the frame loop action symbol is an operator action symbol with a frame loop function symbol, there is a sequence of nodes inside the frame loop action symbol, and each node may accommodates another action symbol; and for the convenience of the description, the sequence of the nodes of the frame loop action symbol is referred to as a frame loop sequence and the frame loop action symbol is shortly referred to as a main procedure frame loop action symbol;
the software process graph receives and responds to the command from the actual software modeling environment to add a condition action symbol in the frame loop sequence of the main procedure frame loop action symbol, wherein the condition action symbol is shortly referred to as a main procedure condition action symbol and is an operator action symbol with a condition logic function symbol which has two branch action symbol sequences corresponding to the "true" condition and the "false" condition, respectively;
in the foregoing steps, adding a component action symbol, shortly referred to as a business operation action symbol, based on the business operation function symbol of the involved software component class symbol in the branch action symbol sequence of the main procedure condition action symbol corresponding to the "true" condition, and then successionally adding an action symbol, shortly referred to as an operation display and control action symbol, based on the operation display and control function symbol of the involved software component class symbol in the branch action symbol sequence of the main procedure condition action symbol corresponding to the "true" condition, and adding a component action symbol, shortly referred to as a configuration display and control action symbol, based on the configuration display and control function symbol of the involved software component class symbol in the branch action symbol sequence of the main procedure condition action symbol corresponding to the "false" condition.

So far, the main business procedure process view is accomplished.

### Configuration display and control process view

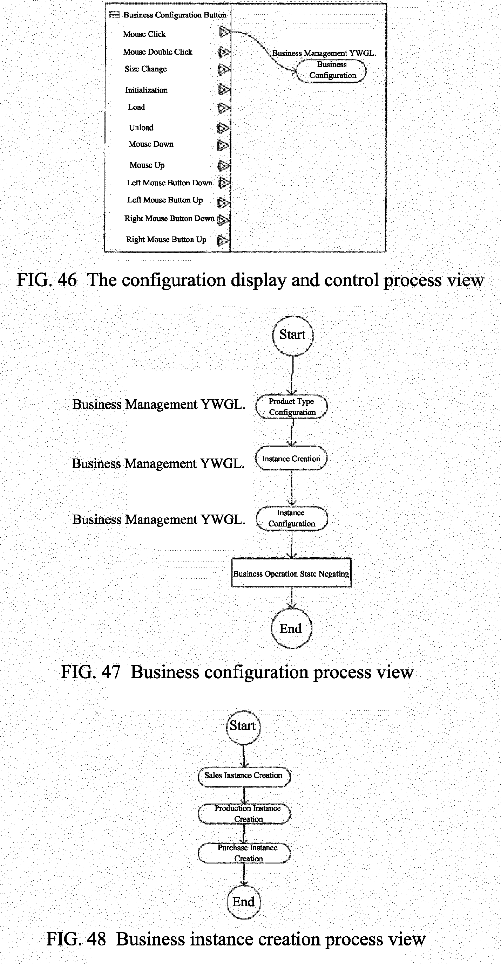

As shown in Fig. 46, the construction procedure of the configuration display and control process view is similar to that of "main business procedure process view" and the content thereof is as follows:
adding an action symbol based on the business configuration function symbol of the involved software component class symbol, shortly referred to as a business configuration action symbol; and establishing an event association between the mouse click event symbol of the business configuration button symbol in the business display interaction view and the business configuration action symbol.

### Business configuration process view

As shown in Fig. 47, the construction procedure of the business configuration process view is similar to that for the "main business procedure process view" and the content thereof is as follows:
adding, in the business configuration root action symbol, the command based on the component action symbol for the product type configuration function symbol of the involved software component class symbol and adding, in the business configuration root action symbol, a product type configuration action symbol which is shortly referred to as the business product type configuration action symbol; adding, in the business configuration root action symbol, the command based on the component action symbol for the instance creation function symbol of the involved software component class symbol and adding, in the business configuration root action symbol, an instance creation action symbol which is shortly referred to as the business instance creation action symbol; adding, in the business configuration root action symbol, the command based on the component action symbol for the instance configuration function symbol of the involved software component class symbol and adding, in the business configuration root action symbol, an instance configuration action symbol which is shortly referred to as the business instance configuration action symbol; adding, in the business configuration root action symbol, a negating operator action symbol which is shortly referred to as the business operation state negating action symbol.

### Business instance creation process view

As shown in Fig. 48, the construction procedure of the business instance creation process view is similar to that of "main business procedure process view" and the content thereof is as follows:
adding, in the instance creation root action symbol, an instance creation operator action symbol which is shortly referred to as the sales instance creation action symbol, wherein the instance creation operator action symbol is an operator action symbol with a function symbol for creating the software component instance and has a component class symbol attribute symbol and an instance quantity attribute symbol; adding, in the instance creation root action symbol, an instance creation operator action symbol which has a component class symbol attribute symbol and instance quantity attribute symbol and which is shortly referred to as the production instance creation action symbol; adding, in the instance creation root action symbol, an instance creation operator action symbol which is shortly referred to as the purchase instance creation action symbol.

### Business instance configuration process view

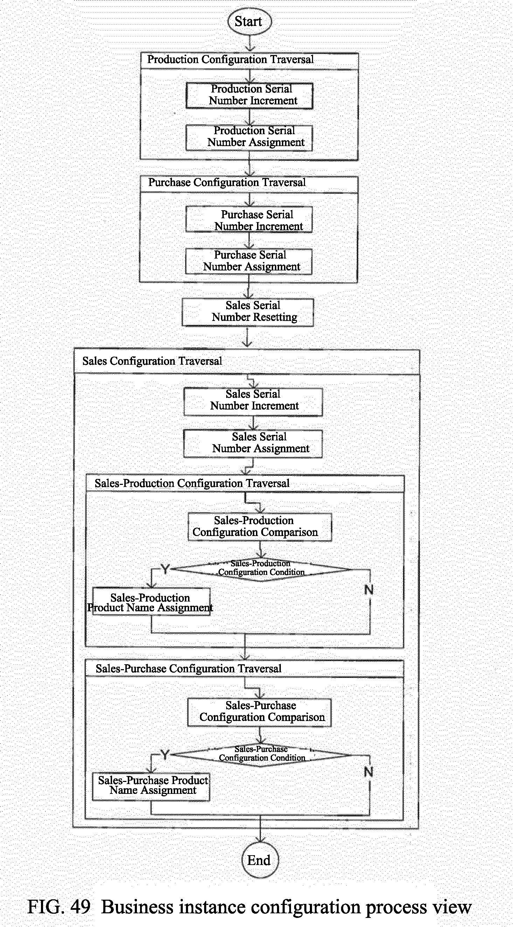

As shown in Fig. 49, the construction procedure of the business instance configuration process view is similar to that of "main business procedure process view" and the content thereof is as follows:
adding, in the business configuration root action symbol, a traversal action symbol is shortly referred to as a production configuration traversal action symbol for the convenience of the description, wherein the traversal action symbol is an operator action symbol which is traversally performed on all instances of a specified software component class symbol, and wherein, inside the traversal action symbol, there is a sequence of nodes each whose accommodates an action symbol;
adding, in the sequence of nodes inside the production configuration traversal action symbol, an increment action symbol which is shortly referred to as the production serial number increment action symbol for the convenience of the description, wherein the increment action symbol is a prefabricated operator action symbol with a function symbol for allowing an integer to increase by one; adding, in the sequence of nodes inside the production configuration traversal action symbol, an assignment symbol action symbol which is shortly referred to as the production serial number assignment symbol action symbol;
adding, in the business configuration root action symbol, a traversal action symbol which is shortly referred to as the purchase configuration traversal action symbol;
adding, in the sequence of nodes inside the purchase configuration traversal action symbol, an increment action symbol which is shortly referred to as the purchase serial number increment action symbol; adding, in the sequence of nodes inside the purchase configuration traversal action symbol, an assignment symbol action symbol which is shortly referred to as the purchase serial number assignment symbol action symbol;
adding, in the business configuration root action symbol, an assignment symbol action symbol which is shortly referred to as the sales serial number reset action symbol; adding, in the business configuration root action symbol, a traversal action symbol which is shortly referred to as the sales configuration traversal action symbol;
adding, in the sequence of nodes inside the sales configuration traversal action symbol, an increment action symbol which is shortly referred to as the sales serial number increment action symbol; adding, in the sequence of nodes inside the sales configuration traversal action symbol, an assignment symbol action symbol which is shortly referred to as the sales serial number assignment symbol action symbol; adding, in the sequence of nodes inside the sales configuration traversal action symbol, a traversal action symbol which is shortly referred to as the sales-production configuration traversal action symbol;
adding, in the sequence of nodes inside the sales-production configuration traversal action symbol, a consistency comparison action symbol which is shortly referred to as the sales-production configuration comparison action symbol and which is an operator action symbol with a decision function symbol for comparing whether or not two inputs are consistent; adding, in the sequence of nodes inside the sales-production configuration traversal action symbol, a condition action symbol which is shortly referred to as the sales-production configuration condition action symbol, which is an operator action symbol with a condition logic function symbol;
adding, in the "true" branch of the sales-production configuration condition action symbol, an assignment symbol action symbol which is shortly referred to as the sales-production product name assignment symbol action symbol;
adding, in the sequence of nodes inside the sales configuration traversal action symbol, a traversal action symbol which is shortly referred to as the sales-purchase configuration traversal action symbol;
adding, in the sequence of nodes inside the sales-purchase configuration traversal action symbol, a consistency comparison action symbol which is shortly referred to as the sales-purchase configuration comparison action symbol; adding, in the sequence of nodes inside the sales-purchase configuration traversal action symbol, a condition action symbol which is shortly referred to as the sales-purchase configuration condition action symbol;
adding, in the "true" branch of the sales-purchase configuration condition action symbol, an assignment symbol action symbol which is shortly referred to as the sales-purchase product name assignment symbol action symbol.

### Business operation process view

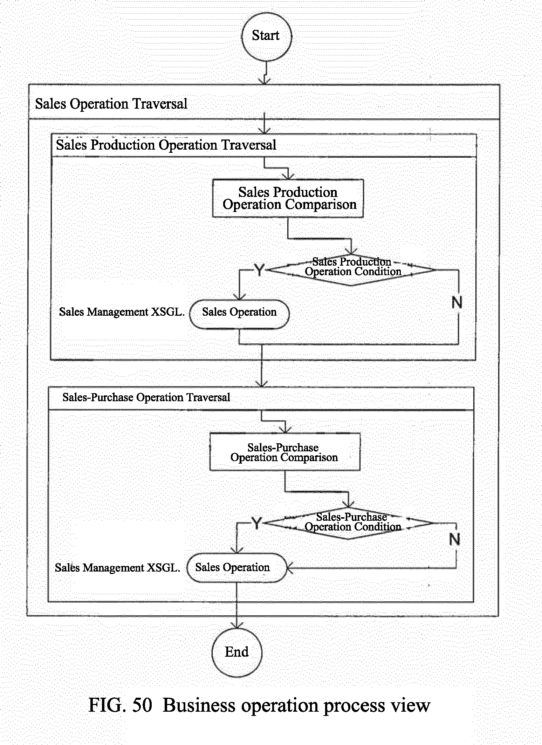

As shown in Fig. 50, the construction procedure of the business operation process view is similar to that of "main business procedure process view" and the content thereof is as follows:
adding, in the business operation root action symbol, a traversal action symbol which is shortly referred to as the sales operation traversal action symbol;
adding, in the sequence of nodes inside the sales operation traversal action symbol, a traversal action symbol which is shortly referred to as the sales-production operation traversal action symbol;
adding, in the sequence of nodes inside the sales-production operation traversal action symbol, a consistency comparison action symbol which is shortly referred to as the sales-production operation comparison action symbol; adding, in the sequence of nodes inside the sales-production operation traversal action symbol, a condition action symbol which is shortly referred to as the sales-production operation condition action symbol;
adding, in the "true" branch of the sales-production operation traversal action symbol, an action symbol based on the sales operation function symbol of the sales management XSGL software component class symbol, shortly referred to as a sales-production operation action symbol;
adding, in the sequence of nodes inside the sales operation traversal action symbol, a traversal action symbol which is shortly referred to as the sales-purchase operation traversal action symbol;
adding, in the sequence of nodes inside the sales-purchase operation traversal action symbol, a consistency comparison action symbol which is shortly referred to as the sales-purchase operation comparison action symbol; adding, in the sequence of nodes inside the sales-purchase operation traversal action symbol, a condition action symbol which is shortly referred to as the sales-purchase operation condition action symbol;
adding, in the "true" branch of the sales-purchase operation traversal action symbol, an action symbol based on the sales operation function symbol of the sales management XSGL software component class symbol, shortly referred to as a sales-purchase operation action symbol.

### Operation display and control process view

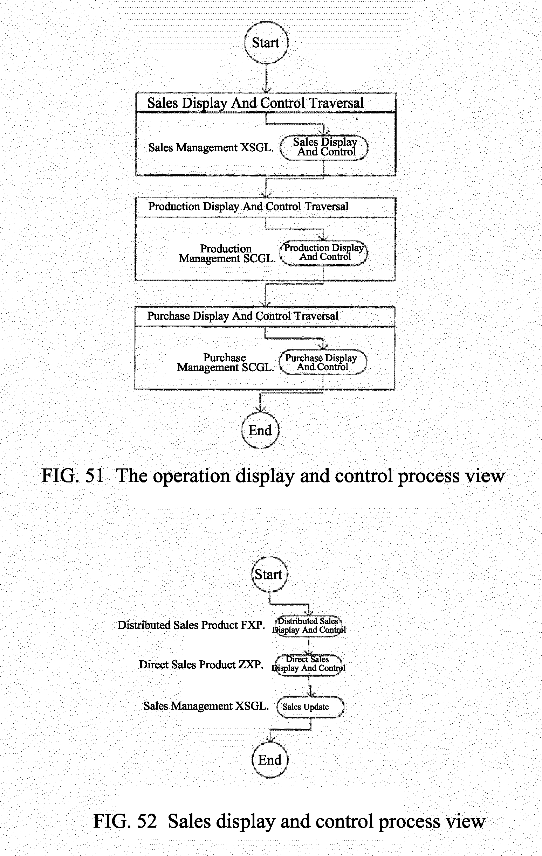

As shown in Fig. 51, the construction procedure of the operation display and control process view is similar to that of "main business procedure process view" and the content thereof is as follows:
adding, in the operation display and control root action symbol, a traversal action symbol which is shortly referred to as the sales display and control traversal action symbol;
adding, in the sequence of nodes in the sales display and control traversal action symbol, an action symbol based on the sales display and control function symbol of the sales management XSGL software component class symbol, shortly referred to as a sales display and control action symbol;
adding, in the operation display and control root action symbol, a traversal action symbol which is shortly referred to as the production display and control traversal action symbol;
adding, in the sequence of nodes in the production display and control traversal action symbol, an action symbol based on the production display and control function symbol of the production management SCGL software component class symbol, shortly referred to as a production display and control action symbol;
adding, in the operation display and control root action symbol, a traversal action symbol which is shortly referred to as the purchase display and control traversal action symbol;
adding, in the sequence of nodes in the purchase display and control traversal action symbol, a component action symbol based on the purchase display and control function symbol of the purchase management CGGL software component class symbol, shortly referred to as a purchase display and control action symbol.

### Sales display and control process view

As shown in Fig. 52, the construction procedure of the sales display and control process view is similar to that of "main business procedure process view" and the content thereof is as follows:
adding, in the sales display and control root action symbol, a component action symbol based on the distributed sales display and control function symbol of the distributed sales product FXP software component class symbol, shortly referred to as a distributed sales display and control action symbol; adding, in the sales display and control root action symbol, a component action symbol based on the direct sales display and control function symbol of the direct sales product ZXP software component class symbol, shortly referred to as a direct sales display and control action symbol; adding, in the sales display and control root action symbol, a component action symbol based on the sales update function symbol of the involved software component class symbol, shortly referred to as a sales update action symbol.

### Sales operation process view

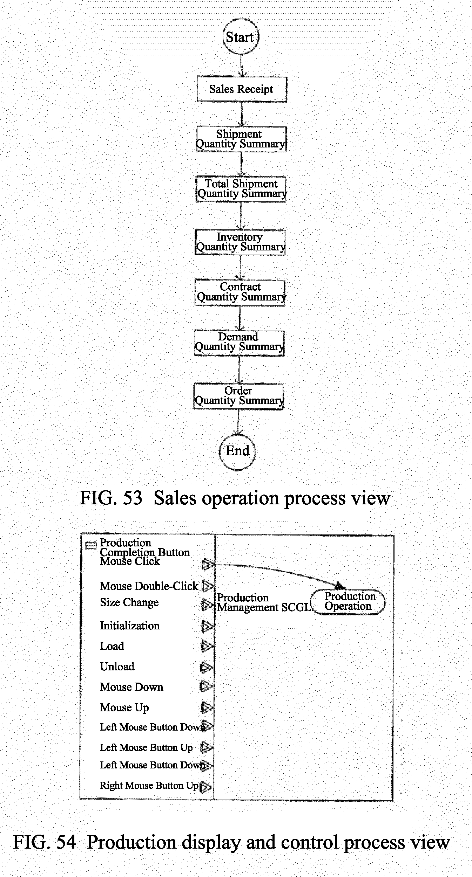

As shown in Fig. 53, the construction procedure of the sales operation process view is similar to that of "main business procedure process view" and the content thereof is as follows:
adding, in the sales operation root action symbol, an addition action symbol which is shortly referred to as the sales receipt action symbol and which is an operator action symbol with an addition function symbol; adding, in the sales operation root action symbol, an addition action symbol which is shortly referred to as the shipment quantity summary action symbol; adding, in the sales operation root action symbol, an addition action symbol which is shortly referred to as the total shipment quantity summary action symbol; adding, in the sales operation root action symbol, a subtraction symbol action symbol which is shortly referred to as the inventory quantity summary action symbol; adding, in the sales operation root action symbol, an addition action symbol which is shortly referred to as the contract quantity summary action symbol; adding, in the sales operation root action symbol, an addition action symbol which is shortly referred to as the demand quantity summary action symbol; adding, in the sales operation root action symbol, a subtraction symbol action symbol which is shortly referred to as the order quantity summary action symbol.

### Production display and control process view

As shown in Fig. 54, the construction procedure of the production display and control process view is similar to that of "main business procedure process view" and the content thereof is as follows:
adding an action symbol based on the production operation function symbol of the involved software component class symbol, shortly referred to as a production operation action symbol; establishing an event association between the mouse click event symbol of the production completion button symbol in the production display interaction view and the production operation action symbol.

### production operation process view

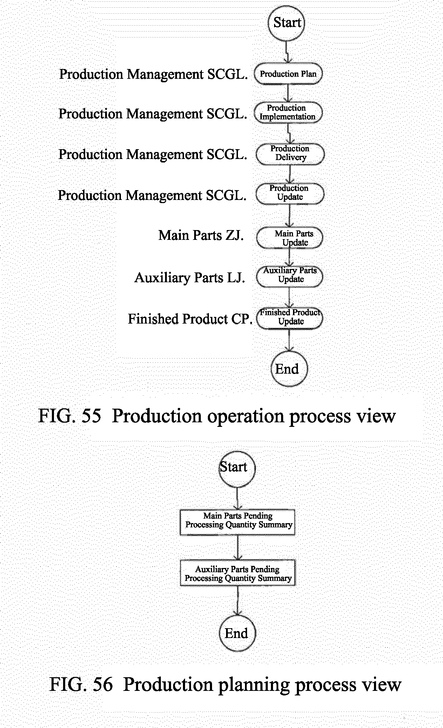

As shown in Fig. 55, the construction procedure of the production operation process view is similar to that of "main business procedure process view" and the content thereof is as follows:
adding, in the production operation root action symbol, an action symbol based on the production planning function symbol of the involved software component class symbol, shortly referred to as a production planning action symbol; adding, in the production operation root action symbol, an action symbol based on the production implementation function symbol of the involved software component class symbol, shortly referred to as a production implementation action symbol; adding, in the production operation root action symbol, an action symbol based on the production delivery function symbol of the involved software component class symbol, shortly referred to as a production delivery action symbol; adding, in the production operation root action symbol, an action symbol based on the production update function symbol of the involved software component class symbol, shortly referred to as a production update action symbol; adding, in the production operation root action symbol, an action symbol based on the main parts update function symbol of the main parts ZJ software component class symbol, shortly referred to as a main parts update action symbol; adding, in the production operation root action symbol, an action symbol based on the auxiliary parts update function symbol of the auxiliary parts LJ software component class symbol, shortly referred to as an auxiliary parts update action symbol; adding, in the production operation root action symbol, an action symbol based on the finished product update function symbol of the finished product CP software component class symbol, shortly referred to as a finished product update action symbol.

### Production planning process view

As shown in Fig. 56, the construction procedure of the production planning process view is similar to that of "main business procedure process view" and the content thereof is as follows:
adding, in the production planning root action symbol, a multiplication action symbol which is shortly referred to as the main parts pending processing quantity summary action symbol and which is an operator action symbol based on the multiplication function symbol of the multiplication operator symbol; adding, in the production planning root action symbol, another multiplication action symbol which is shortly referred to as the auxiliary parts pending processing quantity summary action symbol.

### Production implementation process view

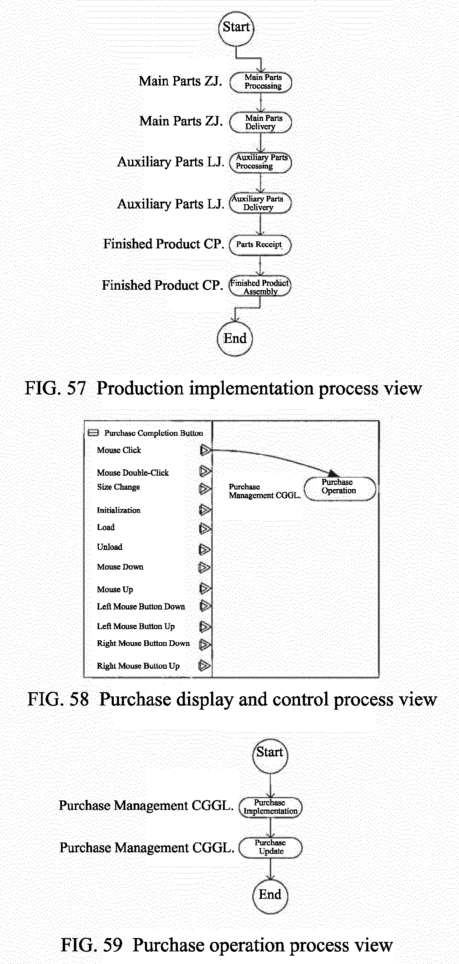

As shown in Fig. 57, the construction procedure of the production implementation process view is similar to that of "main business procedure process view" and the content thereof is as follows:
adding, in the production implementation root action symbol, an action symbol based on the main parts processing function symbol of the main parts ZJ software component class symbol, shortly referred to as a main parts processing action symbol; adding, in the production implementation root action symbol, an action symbol based on the main parts delivery function symbol of the main parts ZJ software component class symbol, shortly referred to as a main parts delivery action symbol; adding, in the production implementation root action symbol, an action symbol based on the auxiliary parts processing function symbol of the auxiliary parts LJ software component class symbol, shortly referred to as an auxiliary parts processing action symbol; adding, in the production implementation root action symbol, an action symbol based on the auxiliary parts delivery function symbol of the auxiliary parts LJ software component class symbol, shortly referred to as an auxiliary parts delivery action symbol; adding, in the production implementation root action symbol, an action symbol based on the auxiliary parts receipt function symbol of the finished product CP software component class symbol, shortly referred to as an auxiliary parts receipt action symbol; adding, in the production implementation root action symbol, an action symbol based on the finished product assembly function symbol of the finished product CP software component class symbol, shortly referred to as a finished product assembly action symbol.

### Purchase display and control process view

As shown in Fig. 58, the construction procedure of the purchase display and control process view is similar to that of "main business procedure process view" and the content thereof is as follows:
adding an action symbol based on the purchase operation function symbol of the involved software component class symbol, shortly referred to as a purchase operation action symbol; establishing an event association between the mouse click event symbol of the purchase completion button symbol in the purchase display interaction view and the purchase operation action symbol.

### Purchase operation process view

As shown in Fig. 59, the construction procedure of the purchase operation process view is similar to that of "main business procedure process view" and the content thereof is as follows:
adding, in the purchase operation root action symbol, an action symbol based on the purchase implementation function symbol of the purchase management CGGL software component class symbol, shortly referred to as a purchase implementation action symbol; adding, in the purchase operation root action symbol, an action symbol based on the purchase update function symbol of the purchase management CGGL software component class symbol, shortly referred to as a purchase update action symbol.

### Distributed sales display and control process view

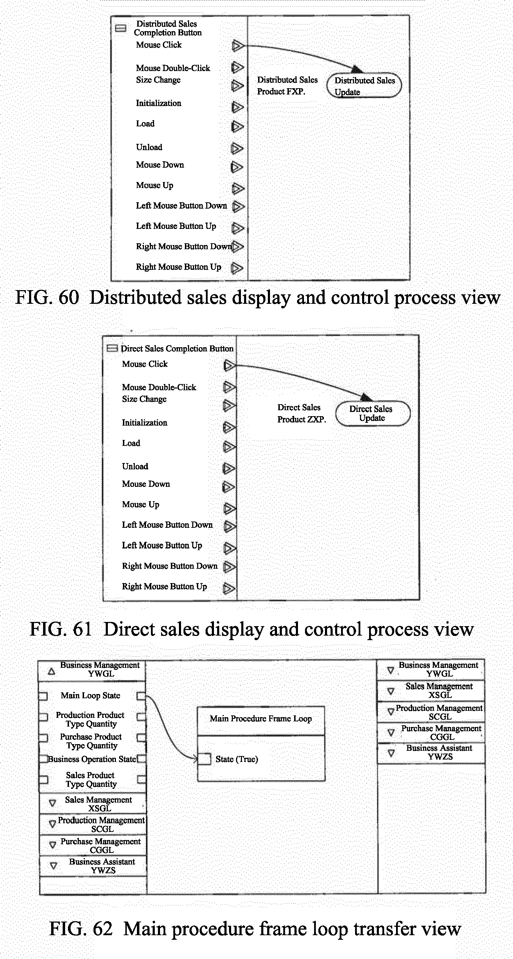

As shown in Fig. 60, the construction procedure of the distributed sales display and control process view is similar to that of "main business procedure process view" and the content thereof is as follows:
adding an action symbol based on the distributed sales update function symbol of the involved software component class symbol, shortly referred to as a distributed sales update action symbol; establishing an event association between the mouse click event symbol of the distributed sales completion button symbol in the distributed sales display interaction view and the distributed sales update action symbol.

### Direct sales display and control process view

As shown in Fig. 61, the construction procedure of the direct sales display and control process view is similar to that of "main business procedure process view" and the content thereof is as follows:
adding an action symbol based on the direct sales update function symbol of the involved software component class symbol, shortly referred to as a direct sales update action symbol; establishing an event association between the mouse click event symbol of the direct sales completion button symbol in the direct sales display interaction view and the direct sales update action symbol.

### Constructing the software transfer views

Next, the construction procedure of the software transfer view for each action symbol will be described in detail.

### Business display transfer view

(null)

### Main procedure frame loop transfer view

Fig. 62 shows a completed main procedure frame loop transfer view whose construction procedure is as follows:
the software hierarchy graph receives and responds to the command from the actual software modeling environment to set the business management YWGL software component class symbol as the involved software component class symbol;
the software interface graph receives and responds to the command from the actual software modeling environment to set the main business procedure function symbol as the involved function symbol;
the software process graph receives command from the actual software modeling environment to set the main procedure frame loop action symbol as the involved action symbol; the software transfer graph constructs a software transfer view for the involved action symbol; for simplicity, the software transfer view for main procedure frame loop action symbol is shortly referred to as the main procedure frame loop transfer view in accordance with name of the involved action symbol; names of software transfer views for other action symbols may be deduced by analogy, which will not be repeated; and
the software transfer graph receives the command from the actual software modeling environment to establish a software transfer symbol from the main loop state attribute symbol of the involved software component class symbol to the state attribute symbol of the involved action symbol; the software transfer graph establishes an input transfer symbol from the main loop state attribute symbol of the business management YWGL software component class symbol to the state attribute symbol of the main procedure frame loop action symbol in response to the foregoing command, wherein the state attribute symbol of the main procedure frame loop action symbol, as a Boolean variable, refers to an abbreviation of a state attribute symbol for the business loop operation action symbol to control whether or not operates; and names of the subsequent action symbol's attribute symbols may be deduced by analogy, which will not be repeated.

So far, the main procedure frame loop transfer view is accomplished.

### Main procedure condition transfer view

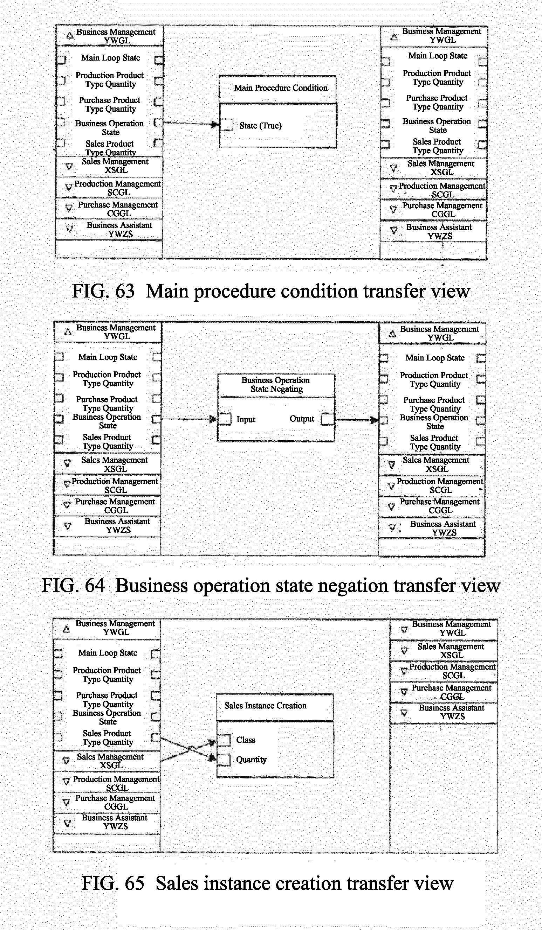

Fig. 63 is a completed main procedure condition transfer view whose construction procedure is similar to that of the "main procedure frame loop transfer view" and the content thereof contains the following transfer:
from the business operation state attribute symbol of the business management YWGL software component class symbol to the state attribute symbol of the main procedure condition action symbol.

### Configuration display and control transfer view

(null)

### Business operation transfer view

(null)

### Operation display and control transfer view

(null)

### Business configuration transfer view

(null)

### Business type configuration transfer view

(null)

### Business instances creation transfer view

(null)

### Business instance configuration transfer view

(null)

### Business operation state negating transfer view

Fig. 64 is a completed business operation state negating transfer view whose construction procedure is similar to that of the "main procedure frame loop transfer view" and the content thereof contains the following transfer symbols:
from the business operation state attribute symbol of the involved software component class symbol to the input of the operation state negating action symbol; and from the output of the operation state negating action symbol to the business operation state attribute symbol of the involved software component class symbol.

### Sales instance creation transfer view

Fig. 65 is a completed sales instance creation transfer view whose construction procedure is similar to that of the "main procedure frame loop transfer view" and the content thereof contains the following transfer symbols:
from the name of the sales management XSGL software component class symbol to the type attribute symbol of the sales instance creation action symbol; and from the sales product type quantity attribute symbol of the involved software component class symbol to the instance quantity attribute symbol of the sales instance creation action symbol.

### Production instance creation transfer view

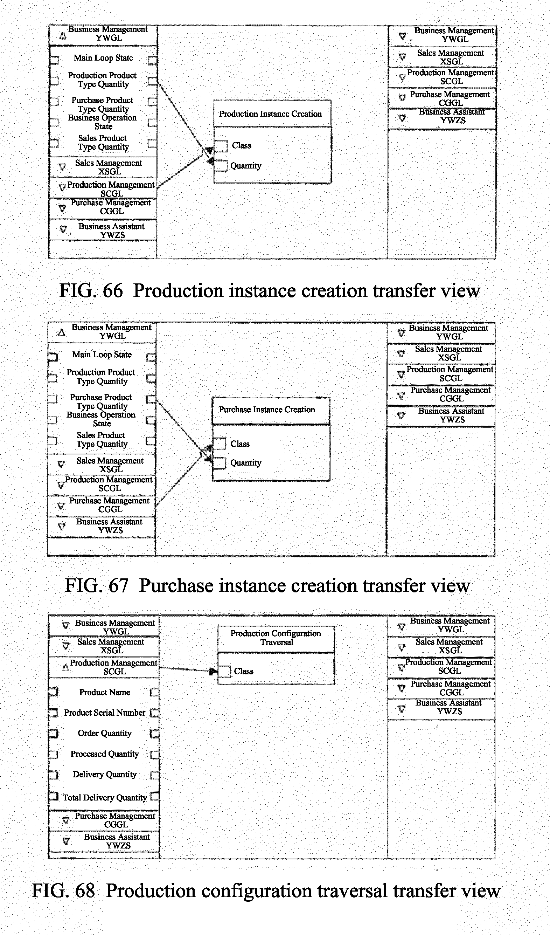

Fig. 66 is a completed production instance creation transfer view whose construction procedure is similar to that of the "main procedure frame loop transfer view" and the content thereof contains the following transfer symbols:
from the name of the production management SCGL software component class symbol to the Component class symbol attribute symbol of the production instance creation action symbol; and from the production product type quantity attribute symbol of the involved software component class symbol to the instance quantity attribute symbol of the production instance creation action symbol.

### Purchase instance creation transfer view

Fig. 67 is a completed purchase instance creation transfer view whose construction procedure is similar to that of the "main procedure frame loop transfer view" and the content thereof contains the following transfer symbols:
from the name of the purchase management CGGL software component class symbol to the Component class symbol attribute symbol of the purchase instance creation action symbol; and from the purchase product type quantity attribute symbol of the involved software component class symbol to the instance quantity attribute symbol of the purchase instance creation action symbol.

### Production configuration traversal transfer view

Fig. 68 is a completed production configuration traversal transfer view whose construction procedure is similar to that of the "main procedure frame loop transfer view" and the content thereof contains the following transfer:
from the name of the production management SCGL software component class symbol to the type attribute symbol of the production configuration traversal action symbol.

### Production serial number increment transfer view

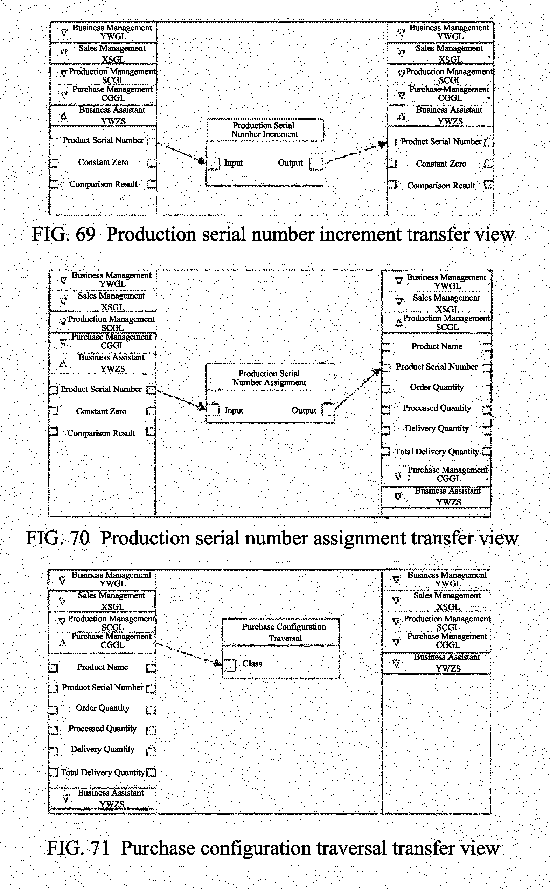

Fig. 69 is a completed production serial number increment transfer view whose construction procedure is similar to that of the "main procedure frame loop transfer view" and the content thereof contains the following transfer symbols:
from the product serial number attribute symbol of the business assistant YWZS software component class symbol to the input attribute symbol of the production serial number increment action symbol; and from the output attribute symbol of the production serial number increment action symbol to the product serial number attribute symbol of the business assistant YWZS software component class symbol.

### Production serial number assignment transfer view

Fig. 70 is a completed production serial number assignment transfer view whose construction procedure is similar to that of the "main procedure frame loop transfer view" and the content thereof contains the following transfer symbols:
from the product serial number attribute symbol of the business assistant YWZS software component class symbol to the input attribute symbol of the production serial number assignment symbol action symbol; and from the output attribute symbol of the production serial number assignment symbol action symbol to the product serial number attribute symbol of the production management SCGL software component class symbol.

### Purchase configuration traversal transfer view

Fig. 71 is a completed purchase configuration traversal transfer view whose construction procedure is similar to that of the "main procedure frame loop transfer view" and the content thereof contains the following transfer:
from the name of the purchase management CGGL software component class symbol to the type attribute symbol of the purchase configuration traversal action symbol.

### Purchase serial number increment transfer view

It is similar to the production serial number increment transfer view.

### Purchase serial number assignment transfer view

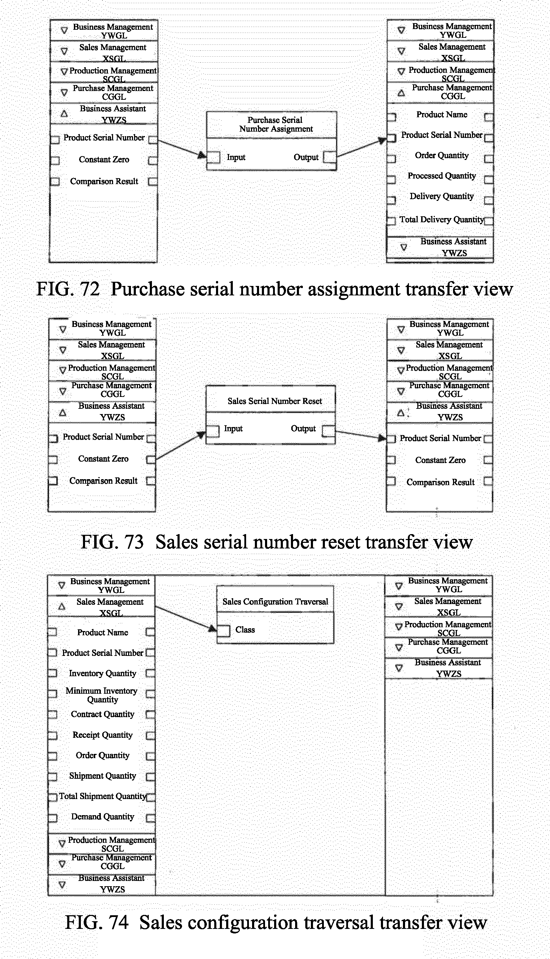

Fig. 72 is a completed purchase serial number assignment transfer view whose construction procedure is similar to that of the "main procedure frame loop transfer view" and the content thereof contains the following transfer symbols:
from the product serial number attribute symbol of the business assistant YWZS software component class symbol to the input attribute symbol of the purchase serial number assignment symbol action symbol; and from the output attribute symbol of the purchase serial number assignment symbol action symbol to the product serial number attribute symbol of the purchase management SCGL software component class symbol.

### Sales serial number reset transfer view

Fig. 73 is a completed sales serial number reset transfer view whose construction procedure is similar to that of the "main procedure frame loop transfer view" and the content thereof contains the following transfer:
from the constant zero attribute symbol of the business assistant YWZS software component class symbol to the input attribute symbol of the sales serial number reset action symbol; and from the output attribute symbol of the sales serial number reset action symbol to the product serial number attribute symbol of the business assistant YWZS software component class symbol.

### Sales configuration traversal transfer view

Fig. 74 is a completed sales configuration traversal transfer view whose construction procedure is similar to that of the "main procedure frame loop transfer view" and the content thereof contains the following transfer:
from the name of the sales management XSGL software component class symbol to the type attribute symbol of the sales configuration traversal action symbol.

### Sales serial number increment transfer view

It is similar to the production serial number increment transfer view.

### Sales serial number assignment transfer view

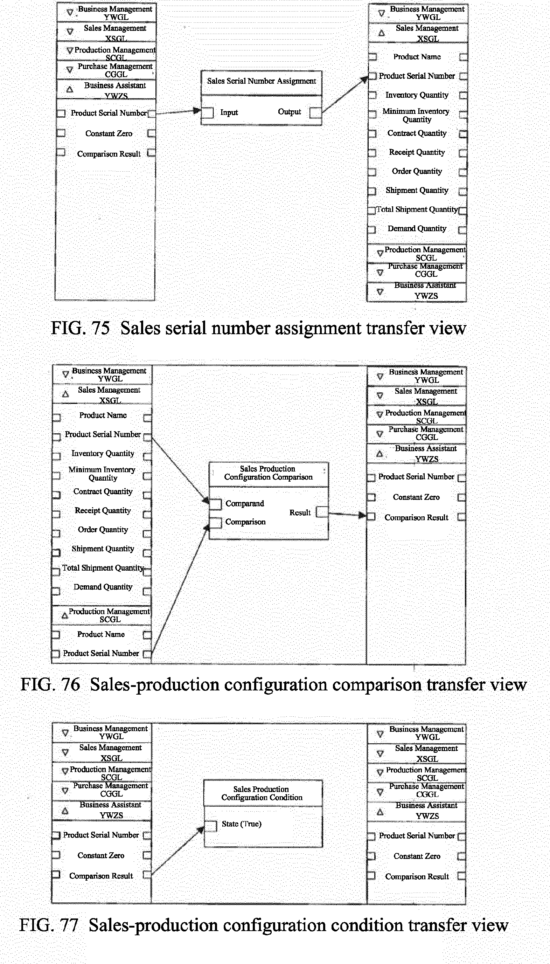

Fig. 75 is a completed sales serial number assignment transfer view whose construction procedure is similar to that of the "main procedure frame loop transfer view" and the content thereof contains the following transfer symbols:
from the product serial number attribute symbol of the business assistant YWZS software component class symbol to the input attribute symbol of the sales serial number assignment symbol action symbol; and from the output attribute symbol of the sales serial number assignment symbol action symbol to the product serial number attribute symbol of the sales management XSGL software component class symbol.

### Sales-production configuration traversal transfer view

It is similar to the production configuration traversal transfer view.

### Sales-production configuration comparison transfer view

Fig. 76 shows a completed sales-production configuration comparison transfer view whose construction procedure is similar to that of the "main procedure frame loop transfer view" and the content thereof contains the following transfer symbols:
from the sales management XSGL software component class symbol' product serial number attribute symbol to sales-production configuration comparison action symbol's comparison attribute symbol; from the production management SCGL software component class symbol' product serial number attribute symbol to sales-production configuration comparison action symbol's comparison attribute symbol; and from the sales-production configuration comparison action symbol's result attribute symbol to the business assistant YWZS software component class symbol' comparison result attribute symbol.

### Sales-production configuration condition transfer view

Fig. 77 shows a completed sales-production configuration condition transfer view whose construction procedure is similar to that of the "main procedure frame loop transfer view" and the content thereof contains the following transfer:
from the business assistant YWZS software component class symbol' comparison result attribute symbol to sales-production configuration condition action symbol's state attribute symbol.

### Sales-production product name assignment transfer view

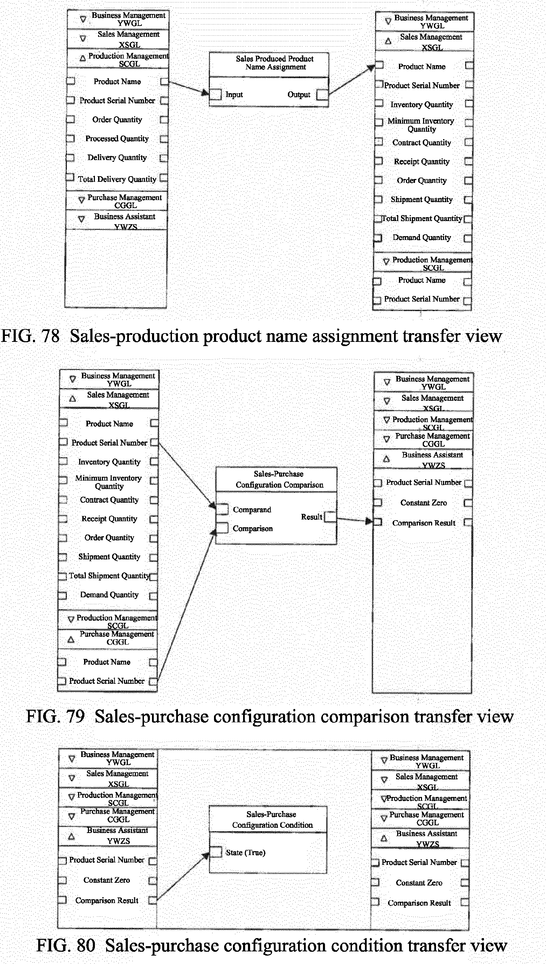

Fig. 78 shows a completed sales-production product name assignment transfer view whose construction procedure is similar to that of the "main procedure frame loop transfer view" and the content thereof contains the following transfer symbols:
from the production management SCGL software component class symbol' product name attribute symbol to sales-production product name assignment symbol action symbol's input attribute symbol; and from the sales-production product name assignment symbol action symbol's output attribute symbol to sales management XSGL software component class symbol' product name attribute symbol.

### Sales-purchase configuration traversal transfer view

It is similar to the purchase configuration traversal transfer view.

### Sales-purchase configuration comparison transfer view

Fig. 79 shows a completed sales-purchase configuration comparison transfer view whose construction procedure is similar to that of the "main procedure frame loop transfer view" and the content thereof contains the following transfer symbols:
from the sales management XSGL software component class symbol' product serial number attribute symbol to the sales-purchase configuration comparison action symbol's comparison attribute symbol; from the purchase management CGGL software component class symbol' product serial number attribute symbol to sales-purchase configuration comparison action symbol's comparison attribute symbol; and from the sales-purchase configuration comparison action symbol's result attribute symbol to business assistant YWZS software component class symbol' comparison result attribute symbol.

### Sales-purchase configuration condition transfer view

Fig. 80 shows a completed sales-purchase configuration condition transfer view whose construction procedure is similar to that of the "main procedure frame loop transfer view" and the content thereof contains the following transfer symbols:
from the business assistant YWZS software component class symbol' comparison result attribute symbol to the sales-purchase configuration condition action symbol's state attribute symbol.

### Sales-purchase product name assignment transfer view

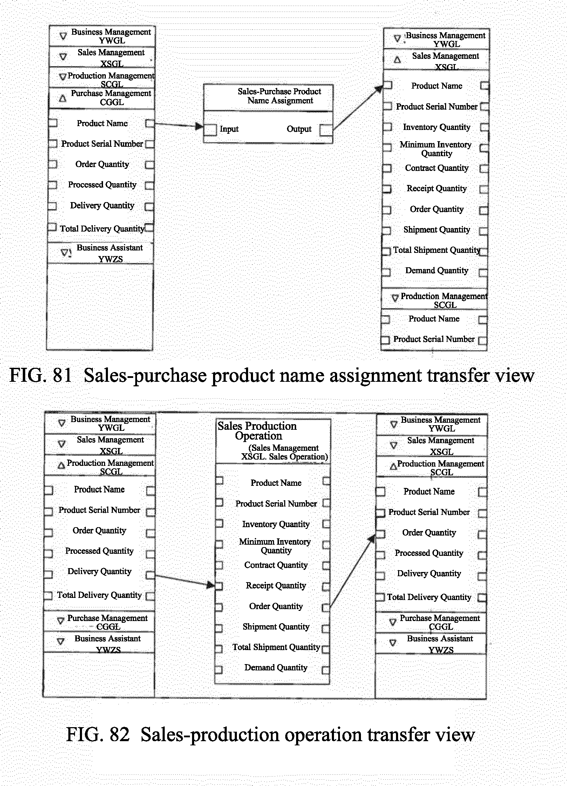

Fig. 81 shows a completed sales-purchase product name assignment transfer view whose construction procedure is similar to that of the "main procedure frame loop transfer view" and the content thereof contains the following transfer symbols:
from the purchase management CGGL software component class symbol' product name attribute symbol to sales-purchase product name assignment symbol action symbol's input attribute symbol; and from sales-purchase product name assignment symbol action symbol's output attribute symbol to sales management XSGL software component class symbol' product name attribute symbol.

### Sales operation traversal transfer view

It is similar to the sales configuration traversal transfer view.

### Sales-production operation traversal transfer view

It is similar to the sales-production configuration traversal transfer view.

### Sales-production operation comparison transfer view

It is similar to the sales-production configuration comparison transfer view.

### Sales-production operation condition transfer view

It is similar to the sales-production configuration condition transfer view.

### Sales-production operation transfer view

Fig. 82 shows a completed sales-production operation transfer view whose construction procedure is similar to that of the "main procedure frame loop transfer view" and the content thereof contains the following transfer symbols:
from the production management SCGL software component class symbol' delivery quantity attribute symbol to sales-production operation action symbol's receipt quantity attribute symbol; and from the sales-production operation action symbol's order quantity attribute symbol to production management SCGL software component class symbol' order quantity attribute symbol.

### Sales-purchase operation traversal transfer view

It is similar to the sales-purchase configuration traversal transfer view.

### Sales-purchase operation comparison transfer view

It is similar to the sales-purchase configuration comparison transfer view.

### Sales-purchase operation condition transfer view

It is similar to the sales-purchase configuration condition transfer view.

### Sales-purchase operation transfer view

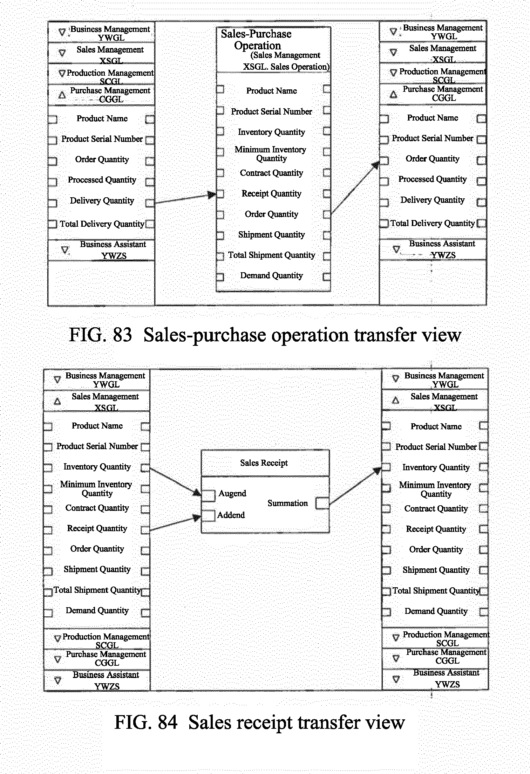

Fig. 83 shows a completed sales-purchase operation transfer view whose construction procedure is similar to that of the "main procedure frame loop transfer view" and the content thereof contains the following transfer symbols:
from the purchase management CGGL software component class symbol' delivery quantity attribute symbol to the sales-purchase operation action symbol's receipt quantity attribute symbol; and from the sales-purchase operation action symbol's order quantity attribute symbol to sales management XSGL software component class symbol' pending purchase quantity attribute symbol.

### Sales receipt transfer view

Fig. 84 shows a completed sales receipt transfer view whose construction procedure is similar to that of the "main procedure frame loop transfer view" and the content thereof contains the following transfer symbols:
from the inventory quantity attribute symbol of the sales management XSGL software component class symbol to the augend attribute symbol of the sales receipt action symbol; from the receipt quantity attribute symbol of the sales management XSGL software component class symbol to the addend attribute symbol of the sales receipt action symbol, and from the summation attribute symbol of the sales receipt action symbol to the inventory quantity attribute symbol of the sales management XSGL software component class symbol.

### Shipment quantity summary transfer view

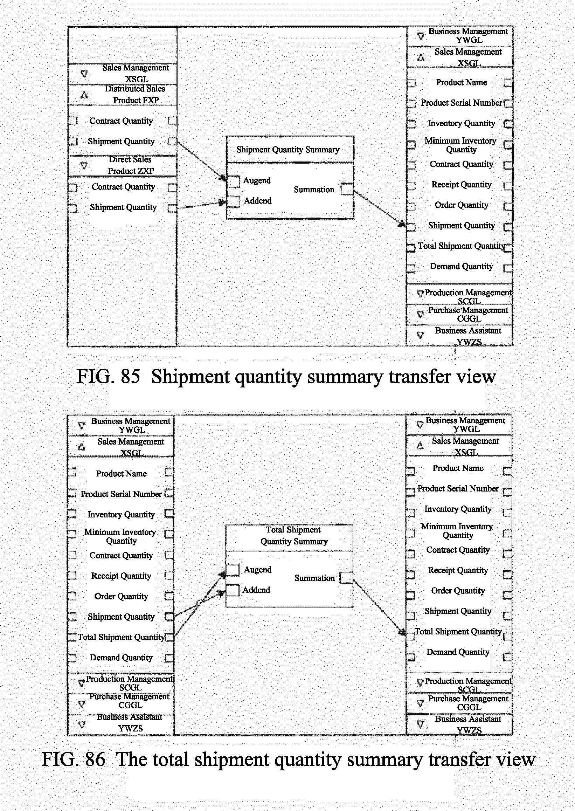

Fig. 85 is a completed shipment quantity summary transfer view whose construction procedure is similar to that of the "main procedure frame loop transfer view" and the content thereof contains the following transfer symbols:
from the shipment quantity attribute symbol of the distributed sales product FXP software component class symbol to the augend attribute symbol of the shipment quantity summary action symbol; from the shipment quantity attribute symbol of the direct sales product ZXP software component class symbol to the addend attribute symbol of the shipment quantity summary action symbol; and from the summation attribute symbol of the shipment quantity summary action symbol to the shipment quantity attribute symbol of the sales management XSGL software component class symbol.

### Total shipment quantity summary transfer view

Fig. 86 is a completed total shipment quantity summary transfer view whose construction procedure is similar to that of the "main procedure frame loop transfer view" and the content thereof contains the following transfer symbols:
from the shipment quantity attribute symbol of the sales management XSGL component class symbol to the augend attribute symbol of the total shipment quantity summary action symbol; from the total shipment quantity attribute symbol of the sales management XSGL software component class symbol to the addend attribute symbol of the total shipment quantity summary action symbol; and from the summation attribute symbol of the total shipment quantity summary action symbol to the total shipment quantity attribute symbol of the sales management XSGL software component class symbol.

### Inventory quantity summary transfer view

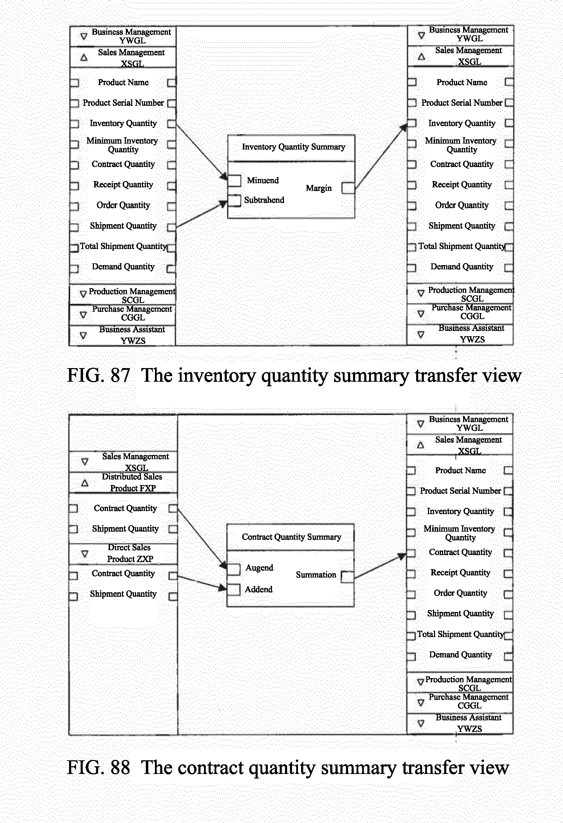

Fig. 87 is a completed inventory quantity summary transfer view whose construction procedure is similar to that of the "main procedure frame loop transfer view" and the content thereof contains the following transfer symbols:
from the inventory quantity attribute symbol of the sales management XSGL component class symbol to the minuend attribute symbol of the inventory quantity summary action symbol; from the shipment quantity attribute symbol of the sales management XSGL software component class symbol to the subtrahend attribute symbol of the inventory quantity summary action symbol, and from the margin attribute symbol of the inventory quantity summary action symbol to the inventory quantity attribute symbol of the sales management XSGL software component class symbol.

### Contract quantity summary transfer view

Fig. 88 is a completed contract quantity summary transfer view whose construction procedure is similar to that of the "main procedure frame loop transfer view" and the content thereof contains the following transfer symbols:
from the contract quantity attribute symbol of the distributed sales product FXP software component class symbol to the augend attribute symbol of the contract quantity summary action symbol; from the contract quantity attribute symbol of the direct sales product ZXP software component class symbol to the addend attribute symbol of the contract quantity summary action symbol, and from the summation attribute symbol of the contract quantity summary action symbol to the contract quantity attribute symbol of the sales management XSGL software component class symbol.

### Demand quantity summary transfer view

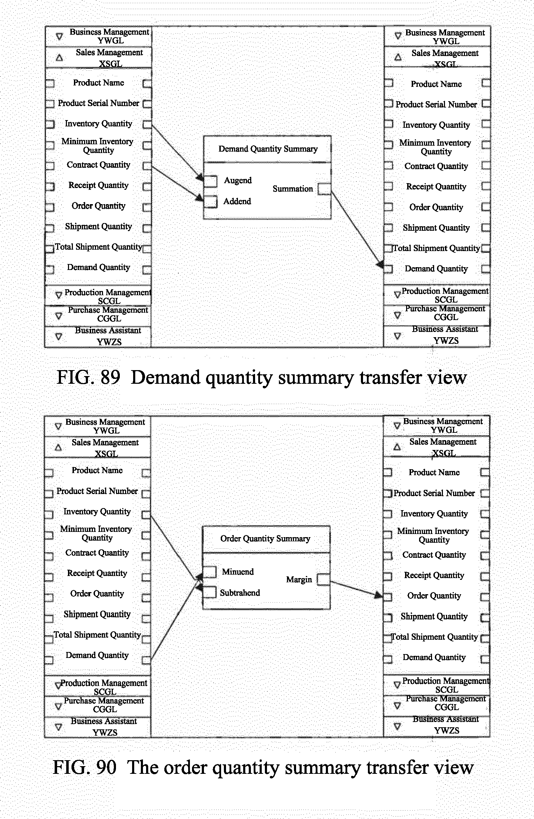

Fig. 89 is a completed demand quantity summary transfer view whose construction procedure is similar to that of the "main procedure frame loop transfer view" and the content thereof contains the following transfer symbols:
from the contract quantity attribute symbol of the sales management XSGL component class symbol to the augend attribute symbol of the demand quantity summary action symbol; from the minimum inventory attribute symbol of the sales management XSGL software component class symbol to the addend attribute symbol of the demand quantity summary action symbol, and from the summation attribute symbol of the demand quantity summary action symbol to the demand quantity attribute symbol of the sales management XSGL software component class symbol.

### Order quantity summary transfer view

Fig. 90 is a completed order quantity summary transfer view whose construction procedure is similar to that of the "main procedure frame loop transfer view" and the content thereof contains the following transfer symbols:
from the demand quantity attribute symbol of the sales management XSGL component class symbol to the minuend attribute symbol of the order quantity summary action symbol; from the inventory quantity attribute symbol of the sales management XSGL software component class symbol to the subtrahend attribute symbol of the order quantity summary action symbol, and from the margin attribute symbol of the order quantity summary action symbol to the order quantity attribute symbol of the sales management XSGL software component class symbol.

### Sales display and control transfer view

(null)

### Distributed sales display and control transfer view

(null)

### Direct sales display and control transfer view

(null)

### Sales update transfer view

(null)

### Production display and control traversal transfer view

It is similar to the production configuration traversal transfer view.

### Production display and control transfer view

(null)

### Production operation transfer view

(null)

### Production planning transfer view

(null)

### Production implementation transfer view

(null)

### Production delivery transfer view

(null)

### Production update transfer view

(null)

### Main parts pending processing quantity summary transfer view

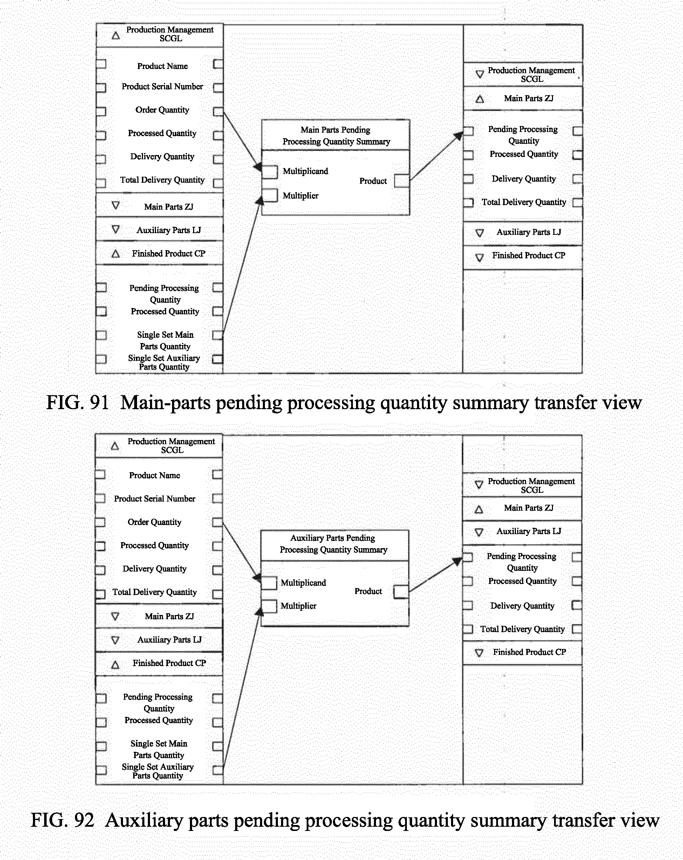

Fig. 91 is a completed main parts pending processing quantity summary transfer view whose construction procedure is similar to that of the "main procedure frame loop transfer view" and the content thereof contains the following transfer symbols:
from the order quantity attribute symbol of the production management SCGL software component class symbol to the multiplicand attribute symbol of the main parts pending processing quantity summary action symbol; from the single set main parts quantity attribute symbol of the finished product CP software component class symbol to the multiplier attribute symbol of the main parts pending processing quantity summary action symbol; and from the product attribute symbol of the main parts pending processing quantity summary action symbol to the pending processing quantity attribute symbol of the main parts ZJ software component class symbol.

### Auxiliary parts pending processing quantity summary transfer view

Fig. 92 is a completed auxiliary parts pending processing quantity summary transfer view whose construction procedure is similar to that of the "main procedure frame loop transfer view" and the content thereof contains the following transfer symbols:
from the order quantity attribute symbol of the production management SCGL software component class symbol to the multiplicand attribute symbol of the auxiliary parts pending processing quantity summary action symbol; from the single set auxiliary parts quantity attribute symbol of the finished product CP software component class symbol to the multiplier attribute symbol of the auxiliary parts pending processing quantity summary action symbol; and from the product attribute symbol of the auxiliary parts pending processing quantity summary action symbol to the pending processing quantity attribute symbol of the auxiliary parts LJ software component class symbol.

### Main parts processing transfer view

(null)

### Main parts delivery transfer view

(null)

### Auxiliary parts processing transfer view

(null)

### Auxiliary parts delivery transfer view

(null)

### Parts receipt transfer view

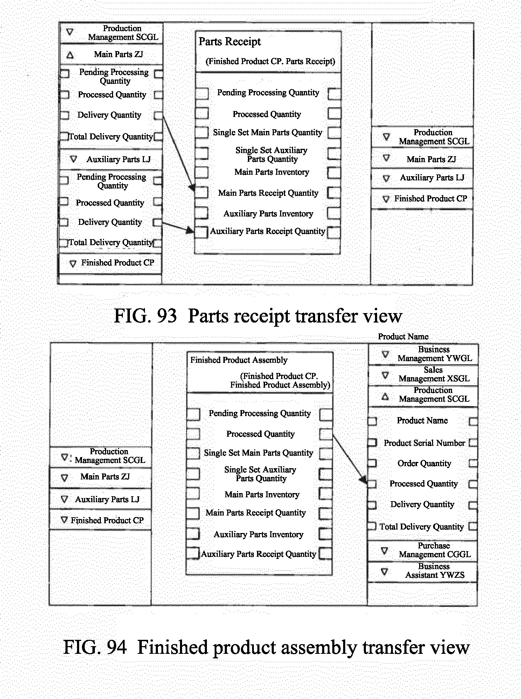

Fig. 93 is a completed parts receipt transfer view whose construction procedure is similar to that of the "main procedure frame loop transfer view" and the content thereof contains the following transfer symbols:
from the delivery quantity attribute symbol of the main parts ZJ software component class symbol to the main parts receipt quantity attribute symbol of the parts receipt action symbol; and from the delivery quantity attribute symbol of the auxiliary parts LJ software component class symbol to the auxiliary parts receipt quantity attribute symbol of the parts receipt action symbol.

### Finished product assembly transfer view

Fig. 94 is a completed finished product assembly transfer view whose construction procedure is similar to that of the "main procedure frame loop transfer view" and the content thereof contains the following transfer:
from the processed quantity attribute symbol of the finished product assembly action symbol to the processed quantity attribute symbol of the production management SCGL software component class symbol.

### Main parts update transfer view

(null)

### Auxiliary parts update transfer view

(null)

### Finished product update transfer view

(null)

### Purchase display and control transfer view

(null)

### Purchase operation transfer view

(null)

### Purchase implementation transfer view

(null)

### Purchase update transfer view

(null)

Thereby, the business management YWGL software view constituted by a software hierarchy view, software interaction views, software interface views, software algorithm views, software process views, and software transfer views in this embodiment has been accomplished.

This embodiment demonstrates how a regular management personnel, without knowledge of any existing complex software modeling languages, without knowledge of any computer programming language, and without dependence on any professional modeler nor any application developer, by using the present invention, independently constructs an executable business management software view based on his vision in business management within a relatively short period of time. The constructed software view is not only clear and simple but also the quality of the constructed software view is significantly higher and the time spent is significantly shorter.

Compared with developing a business management software view with the cooperation of professional modelers and/or application developers, the present invention by which the same manager independently develops the business management software view, achieves remarkable results as follows:
(1) higher quality: the completed software view meets the minds of the managers and avoids the possible bias in understanding of the business management software view between the managers and professional modelers or application developers;
(2) shorter time spent: the entire period of time spent to view is shortened to 1/5 of the original time period because the complex and frequent communications between the managers and the professional modelers or the application developers are eliminated, thereby greatly saving energy and money.

## Claims

1. Visual software modeling method based on software meta-view for constructing software view, by means of a computer readable storage medium having a computer readable program code stored therein, the computer readable program code containing instructions executable by a processor of a computer software to implement a method of constructing software view by processing data conforming to the software meta-view and describing the software view, the software view being a visual representation of a software model, the software meta-view being a visual representation of a software meta model, the software meta-view comprising:
a software hierarchy graph which represents the software hierarchy view of the software view in a tree structure whose nodes are software component class symbols and which is used as a template to be configured in an actual software modeling environment to form the software hierarchy view of the software view, wherein the software hierarchy view refers to a visual representation of the software hierarchy model, wherein the software component class symbol refers to a visual representation of a software component class, and wherein the tree structure, whose nodes are the software component class symbols, is referred as a software hierarchy tree;
a software interface graph which represents software interface views by an optional structure of an attribute symbol set, a function symbol set, and an event symbol set, the software interface graph is used as a template in the actual software modeling environment to be configured to form the software interface views, wherein the software interface views refers to a visual representation of a software interaction model, wherein the function symbols in the function symbol set include software interaction function symbols, software algorithm function symbols, and software process function symbols, wherein the software interaction function symbol is implemented by a software interaction view, wherein the software algorithm function symbol is implemented by a software algorithm view, and wherein the software process function symbol is implemented by a combination of software process views and software transfer views;
a software interaction graph which represents the software interaction views by a tree structure whose nodes are interaction symbols and which is used as a template in the actual software modeling environment to be configured to form the software interaction views, wherein the software interaction view refers to a visual representation of a software interaction model and the interaction symbol refers to a visual representation of an interaction element having an information interaction function with the actual software modeling environment;
a software algorithm graph which represents software algorithm views by a tree structure whose nodes are operator symbols and which is used as a template in the actual software modeling environment to be configured to form the software algorithm view, wherein the software algorithm view refers to a visual representation of a software algorithm model, and wherein the operator symbol refers to a visual representation of an operator;
a software process graph which represents software process views by combining action symbols as nodes and which is used as a template in the actual software modeling environment to configure the software process views, wherein the software process view refers to a visual representation of a software process model and wherein the action symbol refers to a visual representation of an action;
a software transfer graph which represents software transfer views by an input transfer symbol set and an output transfer symbol set which is used as a template in actual software modeling environment to be configured to form the software transfer views, wherein the software transfer view refers to a visual representation of a software transfer model and the transfer symbol refers to a visual representation of a transfer;
specific steps to construct the software view described by the six graphs being as follows:
1) constructing the software hierarchy view: the software hierarchy graph reading in software hierarchy view commands from the actual software modeling environment, wherein the software hierarchy view command refers to command such as creating a software component class symbol, adding a software component class symbol, selecting a software component class symbol, naming a software component class symbol, or deleting a software component class symbol for the hierarchy tree and wherein the software hierarchy graph performs corresponding operations on the software component class symbol nodes in response to software hierarchy view commands to obtain the software hierarchy view;
2) constructing the software interface views: constructing the software interface view for each software component class symbol of the software hierarchy view obtained in the step 1), the steps for constructing each software interface view including: the software interface graph reading in software interface view commands from the actual software modeling environment, wherein the software interface view command refers to command such as creating, naming, or deleting the attribute symbols, the function symbols, and the event symbols, wherein the software interface graph performs corresponding operations in response to the software interface view commands to obtain the software interface view, and wherein the software interaction views corresponding to the software interaction function symbols are constructed by step 3), wherein the software algorithm views corresponding to the software algorithm function symbols are constructed by step 4), and wherein the software process views corresponding to the software process function symbols are constructed by the step 5);
3) constructing the software interactive views: constructing the software interaction view for each software interaction function symbol obtained in the step 2), steps for constructing each software interaction view including: the software interaction graph reading in software interaction view commands from the actual software modeling environment;
4) constructing the software algorithm views: constructing the software algorithm view for each software algorithm function symbol obtained in the step 2), the steps for constructing each software algorithm view including: the algorithm graph reading in software algorithm view commands from the actual software modeling environment;
5) constructing the software process views: constructing the software process view for each software process function symbol obtained in the step 2), the steps for constructing each software process view including: the software process graph reading in software process view commands from the actual software modeling environment; and
6) constructing the software transfer views: constructing the software transfer view for each action symbol in the software process view obtained in the step 5), the steps for constructing each software transfer view including: the software transfer graph reading in software transfer view commands from the actual software modeling environment, wherein the software transfer view command refers to the command such as adding a transfer symbol set, adding a transfer symbol set, or deleting a transfer symbol set and wherein the software transfer graph performs corresponding operations in response to the software transfer view commands to obtain the software transfer view,
thereby, the software view constructed by the software hierarchy view, the software interface views, the software interaction views, the software algorithm views, the software process views, and the software transfer views is accomplished.

2. Visual software modeling method based on software meta-view for constructing software view in claim 1, wherein a combination of the software process graph and the software transfer graph provide a universal means to represent and configure functions corresponding to the function symbols; the software interaction graph provides a simplified alternative for replacing the combination of the software process graph and the software transfer graph if only interaction symbols are used to perform the combination to represent and configure function implementations.

3. Visual software modeling method based on software meta-view for constructing software view in claim 1, wherein a combination of the software process graph and the software transfer graph provide a universal means to represent and configure functions corresponding to the function symbols; the software algorithm graph provides a simplified alternative for replacing the combination of the software process graph and the software transfer graph if only operator symbols are used to perform the combination to represent and configure function implementations.

4. Visual software modeling method based on software meta-view for constructing software view in claim 1, wherein the software meta-view employs a parent-child structure as a base recursive unit to recursively describe the software view; the parent-child structure refers to a structure of parent-child relationships in a software hierarchy tree, constituted by an involved software component class symbol and all child software component class symbols thereof.

5. Visual software modeling method based on software meta-view for constructing software view in claim 1, wherein the specific function symbol of the step 2) can only be any one of the software interaction function symbol, the software algorithm function symbol, and software process function symbol.

6. Visual software modeling method based on software meta-view for constructing software view in claim 1, wherein the software interaction view commands for constructing the software interaction view in the step 3) refer to commands, such as adding an interaction symbol, selecting an interaction symbol, naming an interaction symbol, and deleting an interaction symbol, and the software interaction graph performs corresponding operations in response to the software interaction view commands to obtain the software interaction view; the interaction symbols include operator interaction symbols and component interaction symbols; the operator interaction symbol refers to a visual representation of an operator interaction element and the component interaction symbol refers to a visual representation of a component interaction element, the tree structure whose nodes are the interaction symbols is referred to as an interaction tree.

7. Visual software modeling method based on software meta-view for constructing software view in claim 1, wherein the software algorithm view commands for constructing the software algorithm view in the step 4) refer to commands, such as adding an operator symbol, selecting an operator symbol, naming an operator symbol, and deleting an operator symbol, as well as adding an assignment symbol, selecting an assignment symbol, and deleting an assignment symbol, and the software algorithm graph performs corresponding operations in response to the software algorithm view commands to obtain the software algorithm view; the operator symbols include logic operator symbols and computation operator symbols ; the tree structure whose nodes are the operator symbols is referred to as an algorithm tree; the assignment symbol refers to an assignment relationship representation between two attribute symbols in a set of the algorithm attribute symbols; and the set of the algorithm attribute symbols refers to a collection constituted by a set of attribute symbols of the involved software component class symbols, a set of attribute symbols of all operator symbols, and a set of attribute symbols of all interaction symbols in the software interaction view.

8. Visual software modeling method based on software meta-view for constructing software view in claim 1, wherein the software process view commands for constructing the software process view in step 5) refer to commands such as adding an action symbol, selecting an action symbol, naming an action symbol, and deleting an action symbol, and the software process graph performs a corresponding operation in response to the software process view commands to obtain the software process view; the action symbols include both component action symbols and operator action symbols; the component action symbol, as a visual representation of a component action, refers to one use of a function symbol in the function symbol set in the parent-child structure, the function symbol set in the parent-child structure refers to a collection constituted by the function symbol set of the involved software component class symbol and function symbol sets of all child software component class symbols in the parent-child structure; the operator action symbol, as a visual representation of an operator action, refers to one use of an operator symbol; the software process views include both the attribute process views and the event process views, the software process graph includes both the attribute process graphs and the event process graphs, and the attribute process graph describes the attribute process view through a process tree as the structure, which is a tree structure constituted by action symbols as nodes; the event process graph describes the event process view by a set of event association symbols as the structure; the event association symbol in the set of event association symbols is an association relationship between an event symbol in a set of event symbols in a parent-child structure and an operator action symbol or a component action symbol; the event symbol set in the parent-child structure is a collection constituted by the event symbol set of the involved software component class symbol and the event symbol sets of all interaction symbols in the interaction views thereof and the event symbol sets of all child software component class symbols and the event symbol sets of all interaction symbols in the interaction view thereof, in the parent-child structure.

9. Visual software modeling method based on software meta-view for constructing software view in claim 1, wherein, besides the action attribute symbols which refers to the attribute symbols of the component class symbols where the action symbol is, the attribute symbols relevant to the transfer symbols are limited to the parent-child attribute symbol set, which refers to a collection constituted by all attribute symbol sets of the involved software component class symbols and all attribute symbol sets of all child software component class symbols thereof in the parent-child structure.
